# EUROPÄISCHE PATENTSCHRIFT

(11) **EP 4 771 406 B1**
(45) Veröffentlichungstag und Bekanntmachung des Hinweises auf die Patenterteilung: **30.09.2026**
(21) Anmeldenummer: 25726097.6
(22) Anmeldetag: 15.05.2025
(51) Int. Cl.: G01R 31/34, H02P 25/06, B60L 15/00, B60L 13/03

(54) **VERFAHREN ZUM BETREIBEN EINES LINEAREN TRANSPORTSYSTEMS UND LINEARES TRANSPORTSYSTEM**
METHOD FOR OPERATING A LINEAR TRANSPORT SYSTEM, AND LINEAR TRANSPORT SYSTEM
PROCÉDÉ DE FONCTIONNEMENT D'UN SYSTÈME DE TRANSPORT LINÉAIRE ET SYSTÈME DE TRANSPORT LINÉAIRE

(30) Priorität: 15.05.2024 DE 102024113644
(43) Veröffentlichungstag der Anmeldung: 08.07.2026
(73) Patentinhaber: Beckhoff Automation GmbH, 33415 Verl (DE)
(72) Erfinder: BETTENWORTH, Manuel, 1130 Wien (AT); GRABOWSKI, Marco, 33619 Bielefeld (DE); FREIBERGER, Leon, 33330 Gütersloch (DE); PRÜSSMEIER, Uwe, 32657 Lemgo (DE); ACHTERBERG, Jan, 47249 Duisburg (DE); BERGHOFF, Jannik, 33332 Güttersloch (DE); SCHÖNKE, Tobias, 32051 Herford (DE)
(74) Vertreter: Patentanwaltskanzlei WILHELM & BECK
(86) Internationale Anmeldenummer: PCT/EP2025/063437
(87) Internationale Veröffentlichungsnummer: WO 2025/238170

(56) Entgegenhaltungen:
- EP-A1- 4 296 811
- CN-A- 115 335 255

## Beschreibung

Die Erfindung betrifft ein Verfahren zum Betreiben eines linearen Transportsystems. Die Erfindung betrifft ferner ein lineares Transportsystem.

Aus dem Stand der Technik sind lineare Transportsysteme bekannt. Die Offenlegungsschrift DE 10 2012 204 919 A1 beschreibt beispielsweise ein lineares Transportsystem mit einer beweglichen Einheit, einer stationären Einheit mit einer Führungsschiene zum Führen der beweglichen Einheit sowie einem Linearmotor zum Antreiben der beweglichen Einheit entlang der Führungsschiene, wobei der Linearmotor einen Stator und einen Läufer umfasst, wobei der Stator mehrere entlang der Führungsschiene stationär angeordnete Motormodule aufweist, welche jeweils mehrere Antriebsspulen aufweisen, wobei der Läufer an der beweglichen Einheit angeordnet ist und mehrere Magnete umfasst.

Zum Betreiben des linearen Transportsystems ist eine Kenntnis der Anordnung einzelner Motormodule der stationären Einheit essentiell, um über ein Ansteuern von Antriebsspulen der jeweiligen Motormodule ein Verfahren der beweglichen Einheit entlang der Führungsschiene zu erreichen.

Aus der Druckschrift EP 4 296 811 A1 sind ein Verfahren eines Transportsystems sowie ein Transportsystem bekannt.

Es ist daher eine Aufgabe der Erfindung, ein verbessertes Verfahren zum Betreiben eines linearen Transportsystems und ein verbessertes lineares Transportsystem bereitzustellen.

Diese Aufgabe wird durch das Verfahren und das lineare Transportsystem der unabhängigen Ansprüche gelöst. Vorteilhafte Ausgestaltungen sind in den abhängigen Patentansprüchen angegeben.

Nach einem Aspekt wird ein Computer implementiertes Verfahren zum Betreiben eines lineares Transportsystems mit einer Steuereinheit und einer stationären Einheit mit einer Führungsschiene zum Führen einer beweglichen Einheit und einer Mehrzahl von entlang der Führungsschiene angeordneten Motormodulen bereitgestellt, wobei die Motormodule jeweils Antriebsspulen zum Bereitstellen eines Antriebsmagnetfelds zum Antreiben der beweglichen Einheit entlang der Führungsschiene umfassen, und wobei das Verfahren umfasst:
Ausgeben von Steuersignalen von der Steuereinheit an wenigstens eine Antriebsspule eines als Testmotormodul ausgewählten Motormoduls der Mehrzahl von Motormodulen zum Erzeugen eines Testmagnetfelds des als Testmotormodul ausgewählten Motormoduls in einem Testmagnetfelderzeugungsschritt;
Ausgeben von Steuersignalen durch die Steuereinheit an wenigstens eine Antriebsspule wenigstens eines als Störmotormodul ausgewählten Motormoduls der Mehrzahl von Motormodulen zum Erzeugen einer Störgröße des wenigstens einen als Störmotormodul ausgewählten Motormoduls in einem Störgrößenerzeugungsschritt;
Ermitteln einer durch die Störgröße des als Störmotormodul ausgewählten Motormoduls verursachten Störung des Testmagnetfelds des als Testmotormodul ausgewählten Motormoduls durch die Steuereinheit in einem Störungsermittlungsschritt; und
Ermitteln eines zum als Testmotormodul ausgewählten Motormoduls direkt benachbart angeordneten Motormoduls durch die Steuereinheit in einem Anordnungsermittlungsschritt, falls die ermittelte Störung des Testmagnetfelds durch die Störgröße einen vordefinierten Grenzwert erreicht oder überschreitet.

Hierdurch kann der technische Vorteil erreicht werden, dass ein verbessertes Verfahren zum Betreiben eines linearen Transportsystems bereitgestellt werden kann. Durch das Verfahren können für die Motormodule des Stators der stationären Einheit unmittelbar benachbarte Motormodule ermittelt werden. Bei Unkenntnis einer Positionierung eines Motormodules innerhalb der Mehrzahl von Motormodulen am Stator der stationären Einheit kann über Ansteuerung des jeweiligen Motormoduls und weiterer Motormodule des Stators ermittelt werden, ob und wenn ja welche weiteren Motormodule unmittelbar zum ausgewählten Motormodul benachbart angeordnet sind.

Hierzu wird aus der Mehrzahl von Motormodulen wenigstens ein Motormodul ausgewählt und als Testmotormodul definiert. Für das derart definierte Testmotormodul wird darauffolgend die Bestimmung der direkt zum Testmotormodul benachbart angeordneten Motormodule durchgeführt. Dies umfasst, dass durch die Steuereinheit des linearen Transportsystems zunächst das zuvor ausgewähltes Testmotormodul angesteuert wird, um ein Testmagnetfeld zu generieren. Das Testmagnetfeld ist hierbei als ein Magnetfeld definiert, das durch das Testmotormodul generiert wird. Das Testmagnetfeld kann spezielle vordefinierte Eigenschaften aufweisen. Das Testmagnetfeld ist jedoch primär dadurch gekennzeichnet, dass das Testmagnetfeld durch das Testmotormodul generiert wird.

Ferner wird aus der Mehrzahl von Motormodulen des linearen Transportsystems wenigstens ein weiteres Motormodul ausgewählt, als Störmotormodul definiert und durch die Steuereinheit angesteuert, eine Störgröße zu generieren. Analog zum Testmotormodul ist auch das wenigstens eine Störmotormodul ein übliches Motormodul des Stators und ist ausschließlich dadurch ausgezeichnet, dass dieses zum Erzeugen der Störgröße angesteuert wird. Die entsprechende Störgröße ist wiederum dadurch ausgezeichnet, dass die Störgröße durch das Störmotormodul erzeugt wird. Die Störgröße kann ferner vordefinierte Eigenschaften aufweisen.

Darauffolgend wird überprüft, ob das durch die Störmotormodul generierte Störgröße eine Störung des Testmagnetfelds des Testmotormoduls erzeugt. Wird eine derartige Störung des Testmagnetfelds, die durch die Störgröße des Störmotormoduls verursacht ist, detektiert und erreicht bzw. überschreitet die detektierte Störung des Testmagnetfelds einen vordefinierten Grenzwert, so wird zum Testmotormodul ein unmittelbar benachbartes Motormodul ermittelt.

Durch das beschriebene Verfahren kann somit für ein als Testmotormodul ausgewähltes Motormodul der Mehrzahl von Motormodulen des Stators ermittelt werden, das zum entsprechend als Testmotormodul ausgewählten Motormodul ein unmittelbar benachbartes Motormodul am Stator ausgebildet ist.

Zwei Motormodule sind hierbei im Sinne der Anmeldung unmittelbar zueinander benachbart, falls kein weiteres Motormodul zwischen den beiden Motormodulen angeordnet ist.

Das erfindungsgemäße Verfahren ist insbesondere in Situationen vorteilhaft anwendbar, in denen die Steuereinheit des linearen Transportsystems nicht alle Positionierungen der Motormodule innerhalb des Stators der stationären Einheit kennt. Die Steuereinheit ist zwar in der Lage, die einzelnen Motormodule des Stators fehlerfrei und individuell anzusteuern, die tatsächlichen Positionierungen der Motormodule innerhalb des Stators, sprich die Information, wie die einzelnen Motormodule zueinander benachbart angeordnet sind, ist der Steuereinheit hingegen wenigstens nicht vollständig bekannt.

Diese Situation kann beispielsweise beim Aufstarten des neu aufgebauten linearen Transportsystems auftreten. Zu diesem Zeitpunkt sind die einzelnen Motormodule an der stationären Einheit verbaut und mit der Steuereinheit datentechnisch verbunden. Die Steuereinheit ist ferner in der Lage die einzelnen Motormodule zu identifizieren und individuell anzusteuern. Eine tatsächliche Positionierung der Motormodule an der stationären Einheit, die von dem tatsächlichen Zusammenbau der stationären Einheit, in dem die Motormodule in wenigstens teilweise unbekannter und gegebenenfalls beliebiger Reihenfolge innerhalb des Stators der stationären Einheit verbaut werden, abhängt, ist der Steuereinheit hingegen unbekannt. Ein ähnlicher Fall kann auftreten, wenn einzelne Teile der stationären Einheit des bereits bestehenden linearen Transportsystems ausgetauscht oder modifiziert werden. Die ausgetauschten bzw. neu hinzugefügten Motormodule sind der Steuereinheit auf Softwareebene zwar bekannt, sodass eine individuelle Adressierung bzw. Ansteuerung der Motormodule durch die Steuereinheit problemlos möglich ist. Die tatsächliche Positionierung der einzelnen Motormodule an der stationären Einheit ist der Steuereinheit hingegen weiterhin unbekannt.

Durch das vorliegende Verfahren können somit, durch Ansteuern der verschiedenen Motormodule und durch das oben beschriebene Erzeugen von Testmagnetfeldern und Störgrößen, durch die Steuereinheit automatisch für beliebig auswählbare Motormodule des Stators unmittelbar benachbarte Motormodule ermittelt werden.

Indem das Verfahren für die Mehrzahl von Motormodulen, deren Positionierung der Steuereinheit zum Zeitpunkt des Ausführens des Verfahrens unbekannt ist, fortgesetzt wird, kann die Topologie des Stators, sprich die Positionierung aller Motormodule am Stator, ermittelt bzw. aktualisiert werden.

Eine händische Programmierung der bestehenden Topologie, sprich der Information bezüglich der Positionierungen der einzelnen Motormodule innerhalb des Stators, in die Steuereinheit kann somit vermieden werden.

Eine Störgröße ist im Sinne der Anmeldung eine durch Schaltung des als Störmotormoduls ausgewählten Motormodus erzeugbare Größe, auf der basierend eine Störung des Testmagnetfelds erzeugt und detektiert werden kann.

Nach einer Ausführungsform umfasst der Anordnungsermittlungsschritt:
Identifizieren des wenigstens einen Störmotormoduls als das zum Testmotormodul unmittelbar benachbart angeordnete Motormodul basierend auf einer zeitlichen Abfolge der Erzeugung der Störgröße durch das wenigstens eine Motormodul und der Ermittlung der Störung des Testmagnetfelds durch die Steuereinheit in einem Identifizierungsschritt.

Hierdurch kann der technische Vorteil erreicht werden, dass eine weitere Verbesserung der Ermittlung der Positionierungen der Motormodule innerhalb des Stators ermöglicht ist. Hierdurch kann das zuvor zu dem ausgewählten Testmotormodul ermittelte unmittelbar benachbarte Motormodul mit dem jeweiligen als Störmotormodul ausgewählten Motormodul identifiziert werden. Diese Identifizierung des zum Testmotormodul unmittelbar benachbarten Motormoduls kann beispielsweise dadurch bewirkt werden, dass zum Zeitpunkt der Detektion der durch die Störgröße des Störmotormoduls verursachten Störung des Testmagnetfelds des Testmotormoduls ausschließlich ein Störmotormodul zum Erzeugen der Störgröße von der Steuereinheit angesteuert war. Dieses einzige bestromte Störmotormodul ist dann als das zum Testmotormodul unmittelbar benachbarte Motormodul identifiziert.

Das vorliegende Verfahren basiert auf der Idee, dass eine durch eine Störgröße in einem Testmagnetfeld verursachte Störung primär dann detektiert wird bzw. primär dann den vordefinieren Grenzwert erreicht oder überschreitet, falls das jeweilige die Störgröße erzeugende Störmotormodul unmittelbar benachbart zu dem das Testmagnetfeld erzeugenden Testmotormodul angeordnet ist. Bei einer weiteren Entfernung des Störmotormoduls zum Testmotormodul, beispielsweise bei einer Anordnung eines weiteren Motormoduls zwischen dem Störmotormodul und dem Testmotormodul, ist die Wirkung der durch das Störmotormodul erzeugten Störgröße auf das durch das Testmotormodul erzeugte Testmagnetfeld derart gering, dass entweder keine Störung des Testmagnetfelds detektierbar ist oder die detektierte Störung den vordefinierten Grenzwert nicht erreicht.

Wird somit bei Ansteuerung des Testmotormoduls und Erzeugung eines entsprechenden Testmagnetfelds eine auf einer Störgröße basierende Störung des Testmagnetfelds detektiert und erreicht die detektierte Störung den vordefinierten Grenzwert oder überschreitet diesen, so kann erfindungsgemäß geschlussfolgert werden, dass zu dem als Testmotormodul ausgewählten Motormodul ein unmittelbar benachbartes Motormodul positioniert ist. Kann ferner die detektierte Störung des Testmagnetfelds eindeutig einer Störgröße eines Störmotormoduls zugeordnet werden, so kann das zum Testmotormodul unmittelbar benachbarte Motormodul als dasjenige Störmotormodul identifiziert werden, dass die Störgröße generiert hat, die die Störung des Testmagnetfelds verursacht hat.

Werden zeitgleich mehrere Störmotormodule angesteuert und somit mehrere Störgrößen erzeugt, so kann bei Detektion einer Störung eines Testmagnetfelds eines als Testmotormodul ausgewählten Motormoduls lediglich erkannt werden, dass zu dem Testmotormodul ein unmittelbar benachbartes Motormodul existiert. Dieses unmittelbar benachbarte Motormodul muss dann eines der mehreren Störmotormodule sein. Sind die Positionen der Störmotormodule jedoch nicht bekannt, kann nicht eindeutig bestimmt werden, welches der mehreren angesteuerten Störmotormodule zum Testmotormodul unmittelbar benachbart angeordnet ist.

Werden die mehreren Störmotormodule jedoch zeitlich nacheinander zum Generieren der Störgrößen angesteuert, so kann bei Detektion einer Störung des Testmagnetfelds dasjenige Störmotormodul als zum Testmotormodul unmittelbar benachbartes Motormodul identifiziert werden, das zum Zeitpunkt der Ermittlung der Störung des Testmagnetfelds zum Erzeugen einer Störgröße angesteuert war.

Durch die Identifizierung der ermittelten unmittelbar benachbarten Motormodule zu einem oder mehreren ausgewählten Testmotormodulen kann eine vollständige Information der Topologie des linearen Transportsystems erreicht werden.

Nach einer Ausführungsform umfasst der Störungsermittlungsschritt:
Ermitteln einer Spannungsänderung einer Betriebsspannung der das Testmagnetfeld erzeugenden Antriebsspule des Testmotormoduls durch die Steuereinheit in einem Spannungsänderungsermittlungsschritt, wobei der vordefinierte Grenzwert durch die Spannungsänderung definiert ist.

Hierdurch kann der technische Vorteil erreicht werden, dass durch die Messung der Spannungsänderung der an der zum Generieren des Testmagnetfelds angesteuerten Antriebsspule des Testmotormoduls abfallenden Spannung eine präzise Detektion der Störung des Testmagnetfelds des Testmotormoduls erreicht werden kann. Anhand der Größe der Spannungsänderung kann ferner exakt bestimmt werden, ob die detektierte Störung des Testmagnetfelds den vorbestimmten Grenzwert erreicht oder überschreitet. Hierbei ist der vordefinierte Grenzwert durch einen vordefinierten Wert der minimalen Spannungsänderung definiert.

Nach einer Ausführungsform umfasst die Spannungsänderung eine Änderung einer Spannungsamplitude und/oder eine Änderung einer Spannungsphase.

Hierdurch kann der technische Vorteil erreicht werden, dass durch die Berücksichtigung der Spannungsamplitude bzw. der Spannungsphase der an der Antriebsspule des Testmotormoduls abfallenden Spannung eine präzise Ermittlung der Spannungsänderung und damit verbunden eine präzise Detektion der Störung des Testmagnetfelds bewirkt werden kann.

Nach einer Ausführungsform umfasst der Testmagnetfelderzeugungsschritt:
Ausgeben von Steuersignalen durch die Steuereinheit an die Antriebsspule des Testmotormoduls zum Bestromen der Antriebsspule des Testmotormoduls mit einem ersten Betriebsstrom in einem ersten Bestromungsschritt.

Hierdurch kann der technische Vorteil erreicht werden, dass ein präzises Generieren des Testmagnetfelds durch die entsprechend angesteuerte Antriebsspule des Testmotormoduls erreicht wird.

Nach einer Ausführungsform umfasst der Störgrößenerzeugungsschritt:
Ausgeben von Steuersignalen durch die Steuereinheit an die Antriebsspule des wenigstens einen Störmotormoduls zum Bestromen der Antriebsspule des wenigstens einen Störmotormoduls mit einem zweiten Betriebsstrom und zum Erzeugen eines Störmagnetfelds in einem zweiten Bestromungsschritt, wobei die Störgröße durch das Störmagnetfeld gegeben ist.

Hierdurch kann der technische Vorteil erreicht werden, dass eine präzise Erzeugung der als Störmagnetfeld gegebenen Störgröße durch die entsprechende Ansteuerung der jeweiligen Antriebsspule des Störmotormoduls erreicht wird. In der genannten Ausführungsform ist die Störgröße durch ein Störmagnetfeld gegeben, das durch aktive Bestromung wenigstens einer Antriebsspule des als Störmotormodul ausgewählten Motormoduls erzeugt wird.

Die jeweilige Antriebsspule des Störmotormoduls wird hierbei aktiv mit einem Betriebsstrom beaufschlagt, der eingerichtet ist, das gewünschte Störmagnetfeld zu erzeugen. Der Betriebsstrom kann hierbei vordefiniert sein, um hierüber gewährleisten zu können, dass das generierte Magnetfeld die gewünschten Eigenschaften aufweist.

Die im als Testmotormodul ausgewählten Motormodul detektierbare Störung des Testmagnetfelds basiert hierbei auf einer Wechselwirkung zwischen dem Testmagnetfeld des als Testmotormodul ausgewählten Motormoduls und dem Störmagnetfeld des als Störmotormodul ausgewählten Motormoduls.

Nach einer Ausführungsform umfasst der Störgrößenerzeugungsschritt:
Ausgeben von Steuersignalen durch die Steuereinheit an die Antriebsspule des wenigstens einen Störmotormoduls zum Erzeugen der Störgröße durch Schalten der Antriebsspule des wenigstens einen Störmotormoduls in einen Kurzschlusszustand in einem Schaltschritt, wobei die Störgröße durch einen Kurzschluss in der Antriebsspule des als Störmotormodul ausgewählten Motormoduls gegeben ist.

Hierdurch kann der technische Vorteil erreicht werden, dass eine weitere Alternative zum Erzeugen der Störgröße durch das Störmotormodul ermöglicht ist. In der vorgestellten Ausführungsform ist die Störgröße durch einen Kurzschluss in der wenigstens einen Antriebsspule des als Störmotormodul ausgewählten Motormoduls gegen. Zum Erzeugen der Störgröße wird die jeweilige Antriebsspule des als Störmotormodul ausgewählten Motormoduls nicht aktiv mit einem Betriebsstrom bestromt. Stattdessen wird die jeweilige Antriebsspule in einen Kurzschlusszustand geschaltet. Bei Wechselwirkung der entsprechend kurzgeschlossenen Antriebsspule des Störmotormoduls mit dem Testmagnetfeld des Testmotormoduls wird in der kurzgeschlossenen Antriebsspule des Störmotormoduls eine entsprechende Spannung bzw. ein Strom induziert.

Durch den in der wenigstens einen Antriebsspule des Störmotormoduls induzierten Strom bzw. durch die induzierte Spannung wird ein entsprechendes Störmagnetfeld erzeugt. Die Störgröße ist in der Ausführungsform jedoch primär durch den erzeugten Kurzschlusszustand geben. Die im als Testmotormodul ausgewählten Motormodul detektierbare und durch die Störgröße erzeugte Störung basiert hierbei sowohl auf dem durch Induktion in der Antriebsspule des Störmotormoduls erzeugten Aufbau des Störmagnetfelds als auf der Wechselwirkung zwischen dem Testmagnetfeld und dem Störmagnetfeld. Eine aktive Bestromung der Antriebsspule zum Erzeugen des Störmagnetfelds entfällt hierbei.

Nach einer Ausführungsform weist der erste Betriebsstrom der Antriebsspule des Testmotormoduls einen Verlauf aus der folgenden Liste auf: Sinusförmiger Verlauf, Kosinusförmiger Verlauf, Sägezahnförmiger Verlauf, Dreieckförmiger Verlauf, Rechteckförmiger Verlauf.

Hierdurch kann der technische Vorteil erreicht werden, dass durch die Bestromung der Antriebsspule des Testmotormoduls mit dem kosinus- bzw. sinusförmigen, sägezahnförmigen, dreieckigen, rechteckigen ersten Betriebsstrom eine entsprechend kosinus- bzw. sinusförmige, sägezahnförmige, dreieckige, rechteckige an der jeweiligen Antriebsspule abfallende Betriebsspannung generiert wird. Der entsprechende kosinus- bzw. sinusförmige Verlauf, Sägezahnförmige Verlauf, Dreieckförmige Verlauf, Rechteckförmige Verlauf der an der Antriebsspule des Testmotormoduls abfallenden Betriebsspannung erleichtert die Detektion der Spannungsänderung der Betriebsspannung und damit verbunden die Detektion einer Störung des Testmagnetfelds. Andere Stromverläufe sind ebenfalls denkbar.

Nach einer Ausführungsform weist der zweite Betriebsstrom der Antriebsspule des wenigstens einen Störmotormoduls einen Verlauf aus der folgenden Liste auf: Sinusförmiger Verlauf, Cosinusförmiger Verlauf, Sägezahnförmiger Verlauf, Dreieckförmiger Verlauf, Rechteckförmiger Verlauf , Nullstrom.

Hierdurch kann der technische Vorteil erreicht werden, dass eine präzise Ansteuerung des Störmotormoduls zum Erzeugen der Störgröße ermöglicht ist.

Nach einer Ausführungsform werden für eine Mehrzahl von Störmotormodulen durch Ansteuern der jeweiligen Antriebsspulen der Störmotormodule eine Mehrzahl von Störgrößen erzeugt, wobei für die Mehrzahl von Störgrößen überprüft wird, ob Störungen des Testmagnetfelds des Testmotormoduls ermittelt werden.

Hierdurch kann der technische Vorteil erreicht werden, dass durch die Auswahl mehrerer Motormodule als Störmotormodul und durch das Erzeugen mehrerer Störgrößen für ein ausgewähltes Testmotormodul exakt ermittelt werden kann, ob zu dem jeweiligen Testmotormodul ein unmittelbar benachbartes Motormodul existiert. Hierdurch kann eine vollständige Topologie des Stators bzw. des linearen Antriebssystems erreicht werden.

Nach einer Ausführungsform wird das Erzeugen der Mehrzahl von Störgrößen der Mehrzahl von Störmotormodulen zeitlich nacheinander durchgeführt.

Hierdurch kann der technische Vorteil erreicht werden, dass, indem die mehreren Störgrößen zeitlich nacheinander generiert werden, bei Detektion einer Störung des Testmagnetfelds des Testmotormoduls eindeutig dasjenige Störmotormodul als das zum Testmotormodul unmittelbar benachbartes Motormodul identifiziert werden kann, das zum Zeitpunkt der Detektion der Störung des Testmagnetfelds zum Erzeugen der Störgröße angesteuert war. Für das Testmotormodul kann somit eindeutig bestimmt werden, welche Motormodule zum Testmotormodul unmittelbar benachbart positioniert sind.

Nach einer Ausführungsform werden für eine Mehrzahl von als Testmotormodul ausgewählten Motormodule durch Ansteuern der jeweiligen Antriebsspulen der als Testmotormodule ausgewählten Motormodule eine Mehrzahl von Testmagnetfeldern erzeugt.

Hierdurch kann der technische Vorteil erreicht werden, dass für jedes Motormodul der Mehrzahl von Motormodulen des Stators die jeweiligen unmittelbar benachbarten Motormodule ermittelt werden können. Indem nacheinander jedes Motormodul der Mehrzahl von Motormodulen als Testmotormodul zum Erzeugen des Testmagnetfelds ausgewählt wird und das obige Verfahren durchgeführt wird, kann eine vollständige Bestimmung der Positionierung aller Motormodule im Stator erreicht werden.

Nach einer Ausführungsform werden das Erzeugen der Mehrzahl von Testmagnetfeldern der Mehrzahl von als Testmotormodule ausgewählten Motormodule zeitgleich und das Erzeugen der Mehrzahl von Störgrößen der Mehrzahl von als Störmotormodule ausgewählten Motormodule zeitlich nacheinander durchgeführt, oder das Erzeugen der Mehrzahl von Testmagnetfeldern der Mehrzahl von als Testmotormodule ausgewählten Motormodule werden zeitlich nacheinander und das Erzeugen der Mehrzahl von Störgrößen der Mehrzahl von als Störmotormodul ausgewählten Motormodule werden zeitgleich durchgeführt.

Hierdurch kann der technische Vorteil erreicht werden, dass das zu einer Mehrzahl von Motormodulen jeweilige unmittelbar benachbarte Motormodule ermittelt werden können. Indem die Erzeugung der Testmagnetfelder und/oder Störgrößen zeitgleich ausgeführt wird, kann die Ermittlung der jeweils unmittelbar benachbart angeordneten Motormodule für die Mehrzahl von als Testmotormodule ausgewählten Motormodule möglichst zeitsparend ausgeführt werden.

Nach einer Ausführungsform umfasst das Verfahren ferner:
Ermitteln, dass zum Testmotormodul kein unmittelbar benachbartes Motormodul existiert, falls für keine der erzeugten Störgrößen der als Störmotormodule ausgewählten Motormodule eine Störung des Testmagnetfeld ermittelt wird, in einem weiteren Anordnungsermittlungsschritt.

Hierdurch kann der technische Vorteil erreicht werden, dass Lücken zwischen den Motormodulen und/oder Enden oder Anfänge der durch die Mehrzahl von Motormodulen der stationären Einheit definierten Fahrstrecken der stationären Einheit ermittelt werden können. Als Testmotormodule ausgewählte Motormodule, für die in einer Richtung jeweils kein unmittelbar benachbartes Motormodul ermittelt wird, werden als Ende/Anfang der Fahrtstrecke in der jeweiligen Richtung interpretiert.

Nach einer Ausführungsform sind die Motormodule der Mehrzahl von Motormodulen der stationären Einheit zu Motormodulsträngen zusammengefasst, wobei jeder Motormodulstrang wenigstens zwei miteinander leitungsgebunden verbundene Motormodule aufweist, und wobei das Verfahren umfasst:
Bestimmen eines Testrandmotormoduls eines Testmotormodulstrangs und eines Störrandmotormoduls eines Störmotormodulstrangs durch die Steuereinheit in einem Motormodulbestimmungsschritt, wobei das Testrandmotormodul mit nur einem weiteren Motormodul des Testmotormodulstrangs leitungsgebunden verbunden ist, und wobei das Störrandmotormodul mit nur einem weiteren Motormodul des Störmotormodulstrangs leitungsgebunden verbunden ist; und
Auswählen des Testrandmotormoduls des Testmotormodulstrangs als Testmotormodul zum Erzeugen des Testmagnetfelds und Auswählen des Störrandmotormoduls des Störmotormodulstrangs als Störmotormodul zum Erzeugen der Störgröße durch die Steuereinheit in einem Motormodulauswahlschritt.

Hierdurch kann der technische Vorteil erreicht werden, dass bei der Zusammenfassung von Motormodulen in Motormodulstränge für jeden Motormodulstrang ein unmittelbar benachbarter Motormodulstrang durch Ausführung des erfindungsgemäßen Verfahrens bestimmt werden kann. In einem Motormodulstrang sind die wenigstens zwei Motormodule des jeweiligen Motormodulstrangs leitungsgebunden miteinander verbunden. Die Positionen der Motormodule innerhalb des Motormodulstrangs sind über die leitungsgebundene Verbindung der Steuereinheit bekannt. Die Informationen bezüglich der Positionen, an denen die einzelnen Motormodulstränge im Stator ausgebildet sind, und bezüglich der zueinander benachbarten Motormodulstränge, sind der Steuereinheit hingegen nicht bekannt.

Jeder Motormodulstrang weist wenigstens zwei Randmotormodule auf. Zum Bestimmen der zu einem ausgewählten Motormodulstrang unmittelbar benachbarten Motormodulstränge wird wenigstens eines der wenigstens zwei Randmotormodule als Testrandmotormodul zum Erzeugen eines bzw. zweier Testmagnetfelder ausgewählt. Ferner werden die Randmotormodule der weiteren Motormodulstränge als Störrandmotormodule zum Erzeugen entsprechender Störgrößen ausgewählt.

Hierauf basierend wird das Verfahren gemäß den oben beschriebenen Verfahrensschritten ausgeführt und für das wenigstens eine bzw. die beiden Testrandmotormodule durch die Störgrößen der Störrandmotormodule der weiteren Motormodulstränge verursachte Störungen der jeweiligen Testmagnetfelder ermittelt. Hierüber können die zu einem als Testmotormodulstrang ausgewählten Motormodulstrang unmittelbar benachbarten Motormodulstränge ermittelt werden.

Da die Positionen der Motormodule innerhalb eines Motormodulstrangs bekannt sind, werden als Testmotormodule bzw. Störmotormodule ausschließlich die Randmotormodule der jeweiligen Motormodulstränge ausgewählt. Lediglich diese können zu Motormodulen eines unmittelbar benachbarten weiteren Motormodulstrangs unmittelbar benachbart positioniert sein.

Nach einer Ausführungsform umfasst das Verfahren ferner:
Ermitteln einer Topologie der Motormodule der stationären Einheit durch Ermitteln von wenigstens einem unmittelbar benachbarten Motormodul für jedes Motormodul der Mehrzahl von Motormodulen der stationären Einheit durch die Steuereinheit in einem Topologieermittlungsschritt.

Hierdurch kann der technische Vorteil erreicht werden, dass durch die Ausführung des oben beschriebenen Verfahrens eine vollständige Topologie des linearen Transportsystems ermittelt werden kann.

Nach einer Ausführungsform umfasst das lineare Transportsystem eine an einer beweglichen Einheit ausgebildete Signalübertragungseinrichtung, wobei das Verfahren umfasst: Ausgeben von Steuersignalen durch die Steuereinheit an Antriebsspulen der Motormodule zum Ansteuern der Antriebsspulen zum Positionieren der beweglichen Einheit in einer Übertragungsposition der beweglichen Einheit relativ zur stationären Einheit in einem Positionierungsschritt, wobei in der Übertragungsposition der beweglichen Einheit relativ zur stationären Einheit die Signalübertragungseinrichtung mit einem ersten Übertragungselement in einem Wirkbereich der Störgröße und einem zweiten Übertragungselement in einem Wirkbereich des Testmagnetfelds positioniert ist, und wobei durch die Signalübertragungseinrichtung ein magnetisches Störsignal der Störgröße in den Wirkbereich des Testmagnetfelds übertragen wird.

Hierdurch kann der technische Vorteil erreicht werden, dass durch die Signalübertragungseinrichtung das erfindungsgemäße Verfahren auch für weit beabstandete Motormodule ausgeführt werden kann. Die Signalübertragungseinrichtung umfasst hierzu zwei Übertragungselemente, die jeweils in die Wirkbereiche eines Testmagnetfelds eines als Testmotormodul ausgewählten Motormoduls und den Wirkbereich einer Störgröße eines als Störmotormodul ausgewählten Motormoduls positionierbar sind. Über die Signalübertragungseinrichtung kann das durch die Störgröße erzeugte magnetische Störsignal in den Wirkbereich des Testmagnetfelds des Testmotormoduls eingebracht werden, um hierüber eine Störung des Testmagnetfelds zu bewirken. Über die Signalübertragungseinrichtung können somit Distanzen zwischen Motormodulen überbrückt werden, die ansonsten eine Wirkung der durch die jeweiligen Motormodule erzeugten Störgrößen auf die durch die jeweiligen Motormodule erzeugten Testmagnetfelder verhindern würden.

Indem die Signalübertragungseinrichtung an wenigstens einer beweglichen Einheit des linearen Transportsystems ausgebildet ist, kann durch Bewegen der beweglichen Einheit entlang der Führungsschiene die Signalübertragungseinrichtung an beliebigen Motormodulen positioniert werden, um für die jeweiligen Motormodule durch Ausführen des erfindungsgemäßen Verfahrens die jeweiligen unmittelbar benachbarten Motormodule zu ermitteln.

Nach einer Ausführungsform wird das Verfahren bei einem Aufstarten des linearen Transportsystem und/oder nach einem Hinzufügen und/oder Entfernen eines Motormoduls zu/von der Mehrzahl von Motormodulen durchgeführt.

Hierdurch kann der technische Vorteil erreicht werden, dass das erfindungsgemäße Verfahren zu verschiedenen Zeitpunkten des Betriebs des linearen Transportsystems ausgeführt werden kann. Wie oben bereits beschrieben, kann zum Zeitpunkt des erstmaligen Aufstartens des linearen Transportsystems das vorliegende Verfahren dazu verwendet werden, die der Steuereinheit zu diesem Zeitpunkt unbekannten Positionierungen der verschiedenen Motormodule innerhalb des Stators zu ermitteln. Ferner kann das erfindungsgemäße Verfahren eingesetzt werden, wenn Teile eines bereits bestehenden linearen Transportsystems verändert werden, beispielsweise durch Austauschen bzw. Modifizieren von Motormodulen oder Streckenabschnitten des linearen Transportsystems, und dadurch die jeweiligen Positionen der neu hinzugefügten oder neu angeordneten Motormodule der Steuereinheit noch unbekannt sind. Das Verfahren kann somit zu einem beliebigen Zeitpunkt für verschiedene Streckenabschnitte oder das gesamte lineare Transportsystem verwendet werden.

Nach einem Aspekt wird ein lineares Transportsystem mit einer Steuereinheit und einer stationären Einheit bereitgestellt, wobei die stationäre Einheit eine Führungsschiene zum Führen einer beweglichen Einheit und eine Mehrzahl von entlang der Führungsschiene angeordneten Motormodulen umfasst, wobei die Motormodule jeweils Antriebsspulen zum Bereitstellen eines Antriebsmagnetfelds zum Antreiben der beweglichen Einheit entlang der Führungsschiene umfassen, wobei die Antriebsspulen eingerichtet sind, ein Testmagnetfeld und/oder eine Störgröße zu generieren, wobei die Steuereinheit eingerichtet ist, das Verfahren zum Betreiben eines linearen Transportsystems nach einer der voranstehenden Ausführungsformen auszuführen.

Hierdurch kann der technische Vorteil erreicht werden, dass ein verbessertes lineares Transportsystem bereitgestellt werden kann, dass eingerichtet ist, das erfindungsgemäße Verfahren mit den oben beschriebenen technischen Vorteilen auszuführen.

Nach einer Ausführungsform umfasst das lineare Transportsystem ferner eine Signalübertragungseinrichtung, wobei die Signalübertragungseinrichtung eingerichtet ist, ein magnetisches Störsignal der Störgröße einer Antriebsspule wenigstens eines Störmotormoduls in einen Wirkbereich des Testmagnetfelds einer Antriebsspule eines Testmotormoduls der Mehrzahl von Motormodulen zu übertragen.

Hierdurch kann der technische Vorteil erreicht werden, dass durch die Signalübertragungseinrichtung das erfindungsgemäße Verfahren für Motormodule ausgeführt werden kann, die zu einander beabstandet sind und für die die entsprechend erzeugten Testmagnetfelder und Störmagnetfelder der Störgrößen aufgrund der Distanz keine Wechselwirkung aufweisen, die zu einer Störung des Testmagnetfelds führen würde, die den vordefinierten Grenzwert erreichen oder überschreiten würde.

Nach einer Ausführungsform umfasst die Signalübertragungseinrichtung ein erstes Übertragungselement und ein mit dem ersten Übertragungselement leitungsgebunden verbundenes zweites Übertragungselement, wobei das erste Übertragungselement im Wirkbereich der Störgröße und das zweite Übertragungselement im Wirkbereich des Testmagnetfeld positionierbar sind.

Hierdurch kann der technische Vorteil erreicht werden, dass über die ersten und zweiten Übertragungselemente der Signalübertragungseinrichtung die Distanz zwischen zwei Motormodulen überbrückt werden kann, die ansonsten eine Wirkung der Störgröße auf das Testmagnetfeld verhindern würde.

Nach einer Ausführungsform ist die Signalübertragungseinrichtung an der stationären Einheit ausgebildet, wobei das erste Übertragungselement im Wirkbereich der Störgröße des wenigstens einen Störmotormoduls angeordnet ist, und wobei das zweite Übertragungselement im Wirkbereich des Testmagnetfelds der Antriebsspule des Testmotormoduls angeordnet ist.

Hierdurch kann der technische Vorteil erreicht werden, dass durch die Signalübertragungseinrichtung das Störsignal der Störgröße des Störmotormoduls in den Wirkbereich des Testmagnetfelds des Testmotormoduls eingebracht werden kann. Bei Ansteuerung des Steuermotormoduls und Erzeugen der Störgröße kann durch das über die Signalübertragungseinrichtung in den Wirkbereich des Testmagnetfelds des Testmotormoduls eingebrachte magnetische Störsignal eine Störung des Testmagnetfelds ermittelt werden. Hierüber kann dann das jeweilige Störmotormodul als ein zum Testmotormodul direkt benachbartes Motormodul identifiziert werden

Nach einer Ausführungsform ist die Signalübertragungseinrichtung an der beweglichen Einheit des linearen Transportsystems angeordnet, wobei durch ein Verfahren der beweglichen Einheit entlang der Führungsschiene die erste Übertragungsspule im Wirkbereich der Störgröße und die zweite Übertragungsspule im Wirkbereich des Testmagnetfelds positionierbar sind.

Hierdurch kann der technische Vorteil erreicht werden, dass durch die bewegliche Einheit die Signalübertragungseinrichtung zu beliebigen Motormodulen verfahren werden kann. Die Signalübertragungseinrichtung muss somit nicht für jedes mögliche Motormodul an der stationären Einheit verbaut sein. Durch das Verfahren der beweglichen Einheit kann die Signalübertragungseinrichtung hingegen zu den gewünschten Motormodulen, für die überprüft werden soll, welche Motormodule in direkter Nachbarschaft positioniert sind, transportiert werden. Hierdurch kann die Anzahl der benötigten Signalübertragungseinrichtungen im gesamten linearen Transportsystem substantiell reduziert werden.

Nach einer Ausführungsform sind das erste Übertragungselement als eine erste Übertragungsspule und das zweite Übertragungselement als eine zweite Übertragungsspule ausgebildet, wobei bei Positionierung der ersten Übertragungsspule im Wirkbereich der Störgröße und der zweiten Übertragungsspule im Wirkbereich des Testmagnetfelds durch die Störgröße in der ersten Übertragungsspule ein Spannungssignal induzierbar ist, wobei durch das induzierte Spannungssignal in der zweiten Übertragungsspule ein Stromsignal erzeugbar ist, und wobei durch die durch das Stromsignal bestromte zweite Übertragungsspule ein der Störgröße entsprechendes magnetisches Störsignal generierbar und in den Wirkbereich des Testmagnetfelds einbringbar ist.

Hierdurch kann der technische Vorteil erreicht werden, dass durch die Ausbildung der ersten und zweiten Übertragungselemente als entsprechende erste und zweite Übertragungsspulen eine zuverlässige Übertragung des durch die Störgröße des Störmotormoduls erzeugten Magnetischen Störsignals in den Wirkbereich des Testmagnetfelds des Testmotormoduls erreicht wird.

Die Erfindung wird anhand der beigefügten Figuren näher erläutert. Hierbei zeigen:
- Fig. 1: eine Draufsicht eines linearen Transportsystems gemäß einer Ausführungsform;
- Fig. 2: eine Seitenansicht von zwei Motormodulen des linearen Transportsystems gemäß Figur 1;
- Fig. 3: eine schematische Darstellung des linearen Transportsystems gemäß einer weiteren Ausführungsform;
- Fig. 4: eine grafische Darstellung von verfahrensschritten eines Verfahrens zum Betreiben eines linearen Transportsystems gemäß einer weiteren Ausführungsform;
- Fig. 5: eine schematische Darstellung des linearen Transportsystems gemäß einer weiteren Ausführungsform;
- Fig. 6: eine schematische Darstellung des linearen Transportsystems gemäß einer weiteren Ausführungsform;
- Fig. 7: eine schematische Darstellung des linearen Transportsystems gemäß einer weiteren Ausführungsform;
- Fig. 8: eine schematische Darstellung des linearen Transportsystems gemäß einer weiteren Ausführungsform;
- Fig. 9: ein Flussdiagramm des Verfahrens zum Betreiben eines linearen Transportsystems gemäß einer Ausführungsform;
- Fig. 10: ein weiteres Flussdiagramm des Verfahrens zum Betreiben eines linearen Transportsystems gemäß einer weiteren Ausführungsform;
- Fig. 11: ein weiteres Flussdiagramm des Verfahrens zum Betreiben eines linearen Transportsystems gemäß einer weiteren Ausführungsform;
- Fig. 12: ein weiteres Flussdiagramm des Verfahrens zum Betreiben eines linearen Transportsystems gemäß einer weiteren Ausführungsform;
- Fig. 13: ein weiteres Flussdiagramm des Verfahrens zum Betreiben eines linearen Transportsystems gemäß einer weiteren Ausführungsform;
- Fig. 14: ein weiteres Flussdiagramm des Verfahrens zum Betreiben eines linearen Transportsystems gemäß einer weiteren Ausführungsform; und
- Fig. 15: ein weiteres Flussdiagramm des Verfahrens zum Betreiben eines linearen Transportsystems gemäß einer weiteren Ausführungsform.

Im Folgenden können für gleichwirkende Elemente gleiche Bezugszeichen verwendet werden. Dabei wird gegebenenfalls davon abgesehen, bei jeder Figur diese Elemente erneut zu beschreiben. Trotzdem können diese gleichwirkenden Elemente in allen Ausgestaltungen entsprechend vorgesehen werden.

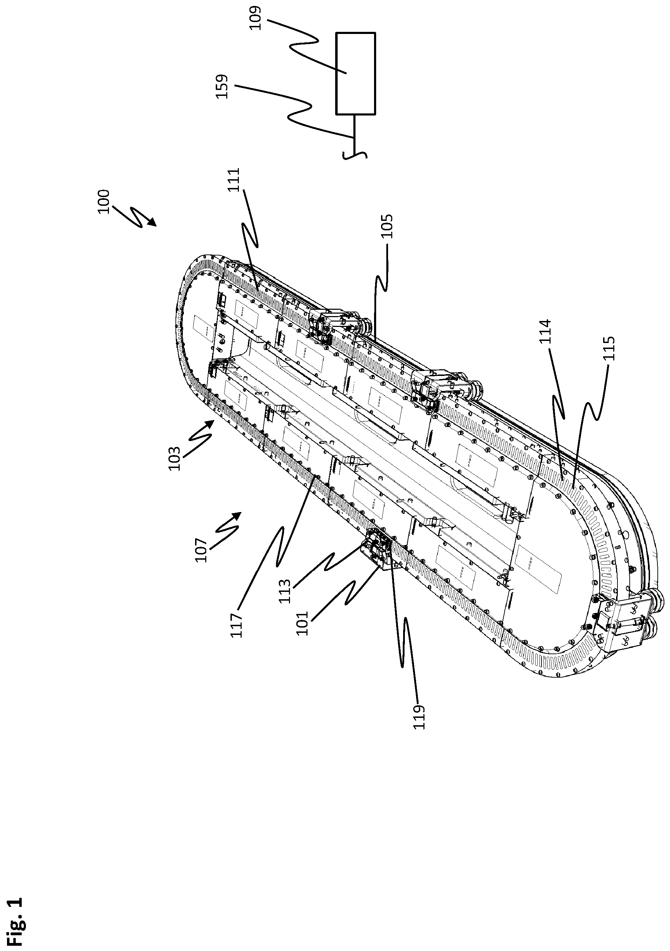

Fig. 1 zeigt eine schematische Draufsicht auf ein lineares Transportsystem 100.

Das lineare Transportsystem 100 weist wenigstens eine bewegliche Einheit 101, eine stationäre Einheit 103 mit einer Führungsschiene 105 zum Führen der wenigstens einen beweglichen Einheit 101 und einen Linearmotor 107 zum Antreiben der beweglichen Einheit 101 entlang der Führungsschiene 105 auf.

Der Linearmotor 107 umfasst einen Stator 111 und wenigstens einen Läufer 113. Der Stator 111 ist an der stationären Einheit 103 ausgebildet, während der wenigstens eine Läufer 113 an der wenigstens einen beweglichen Einheit 101 ausgebildet ist. Der Stator 111 ist zur Führungsschiene 105 benachbart an der stationären Einheit 103 angeordnet und weist mehrere entlang der Führungsschiene 105 stationär angeordnete Statorzähne 114 und in Figur 1 nicht dargestellte Antriebsspulen 115 auf. Jeder zweite Statorzahn 114 ist von einer Anstriebsspule 115 umwickelt und dient somit als Spulenkern für die jeweilige Antriebsspule 115. Die Statorzähne 114 können aus einem ferromagnetischen Material bestehen. Eine Bestromung der Antriebsspulen 115 kann durch die Statorzähne 114 zu einer Verstärkung des Antriebsmagnetfeldes führen.

Der wenigstens eine an der wenigstens einen beweglichen Einheit 101 ausgebildete Läufer 113 umfasst eine Mehrzahl von Antriebsmagnetelementen 119. Über die Antriebsmagnetelemente 119 des Läufers 113 ist ein Läufermagnetfeld erzeugbar. Über die bestrombaren Antriebsspulen 115 sind Statormagnetfelder erzeugbar, sodass über eine magnetische Kopplung zwischen dem Läufermagnetfeld des Läufers 113 der beweglichen Einheit 101 und der durch Bestromung der Antriebsspulen 115 variabel erzeugbaren Statormagnetfelder des Stators 111 eine Bewegung der beweglichen Einheit 101 entlang der Führungsschiene 105 bewirkt werden kann.

Die Mehrzahl der Antriebsspulen 115 des Stators 111 sind in einer Mehrzahl von Motormodulen 117 zusammengefasst. Der Stator 111 umfasst somit mehrere Motormodule 117, die wiederum jeweils eine Mehrzahl von bestrombaren Antriebsspulen 115 umfassen. Die Motormodule 117 sind entlang der Führungsschiene 105 an der stationären Einheit 103 angeordnet. Die Motormodule 117 können einzeln durch die Steuereinheit 109 angesteuert werden.

Ebenfalls in Fig. 1 gezeigt ist, dass das lineare Transportsystem 100 eine Steuereinheit 109 umfasst, die mit einem oder mehreren der Motormodule 117 mittels einer Datenleitung 159 verbunden ist. Insbesondere kann eine Kommunikation zwischen der Steuereinheit 109 und den Motormodulen 117 über einen Datenbus, beispielsweise einen Feldbus, erfolgen, wobei der Datenbus über die Datenleitungen 159 bereitgestellt werden kann.

Insbesondere kann die Steuereinheit 109 ein aktiver Teilnehmer sein und den Datenbus bereitstellen, während die Motormodule 117 passive Teilnehmer sein können, die mit dem Datenbus adressiert werden. Gegebenenfalls kann auch vorgesehen sein, dass jedes der Motormodule 117 direkt mit der Steuereinheit 109 verbunden ist. Die Datenleitungen 159 können ferner auch eine Strom- und/oder Spannungsversorgung der Motormodule 117 bereitstellen. Alternativ ist es möglich, zusätzliche, nicht gezeigte, Leitungen zur Strom- und/oder Spannungsversorgung zu verwenden.

Alternativ kann die Steuereinheit 109 auch in einem oder mehreren Motormodulen 117 ausgebildet sein. Ein Datenaustausch zwischen der Steuereinheit 109 und den Motormodulen 117 kann ferner minimiert sein.

Darüber hinaus können die Leitungen, insbesondere die Datenleitungen 159 aber auch andere Leitungen, steckbar an den Motormodulen 117 angeschlossen sein. Dies kann über entsprechend ausgebildete und in Fig. 1 nicht gezeigte Steckverbinder bewirkt werden. Hierüber kann eine Verbindung der Motormodule 117 zu einer Leistungsversorgung oder der Steuereinheit 109 wie auch die Verbindungen zwischen den Motormodulen 117 bewirkt werden. Die Motormodule 117 können hierzu jeweils beispielsweise zwei Anschlusselemente mit einem Eingangs- und einem Ausgangselement umfassen. Die Anschlusselemente können beispielsweise an den Randbereichen der Motormodule 117 angeordnet sein.

Die Steuereinheit 109 kann eingerichtet sein, Steuerbefehle an die Motormodule 117 auszugeben, um die Motormodule 117 zum Bestromen der Antriebsspulen 115 anzusteuern und hierüber eine Bewegung der beweglichen Einheiten 101 entlang der Führungsschiene 105 zu bewirken.

Zum Betreiben des linearen Transportsystems 100 ist es essentiell, dass die Positionierung jedes Motormoduls 117 an der stationären Einheit 103 der Steuereinheit 109 bekannt ist. Nur so kann die Steuereinheit 109 die richtigen Motormodule 117, bzw. die jeweiligen Antriebsspulen 115, ansteuern, um hierüber die Bewegung der beweglichen Einheiten 101 entlang der Führungsschiene 105 zu ermöglichen.

Bei einem Aufstarten des linearen Transportsystems oder nach einer Modifikation des linearen Betriebssystems 100, bei der zusätzliche Motormodule 117 zu den bereits bestehenden Motormodulen 117 des Stators 111 hinzugefügt wurden, oder bei der bereits bestehende Motormodule 117 des Stators 111 ausgetauscht oder entfernt wurden, ist der Steuereinheit 109 gegebenenfalls nicht jede Position eines jeden Motormoduls 117 am Stator 111 der stationären Einheit 103 bekannt.

Vergleichbar kann der Fall auftreten, dass beim Aufbau Datenleitungen und dazugehörigen Steckplätze für die Datenleitungen an der Steuerung nicht klar sind oder vertauscht wurden.

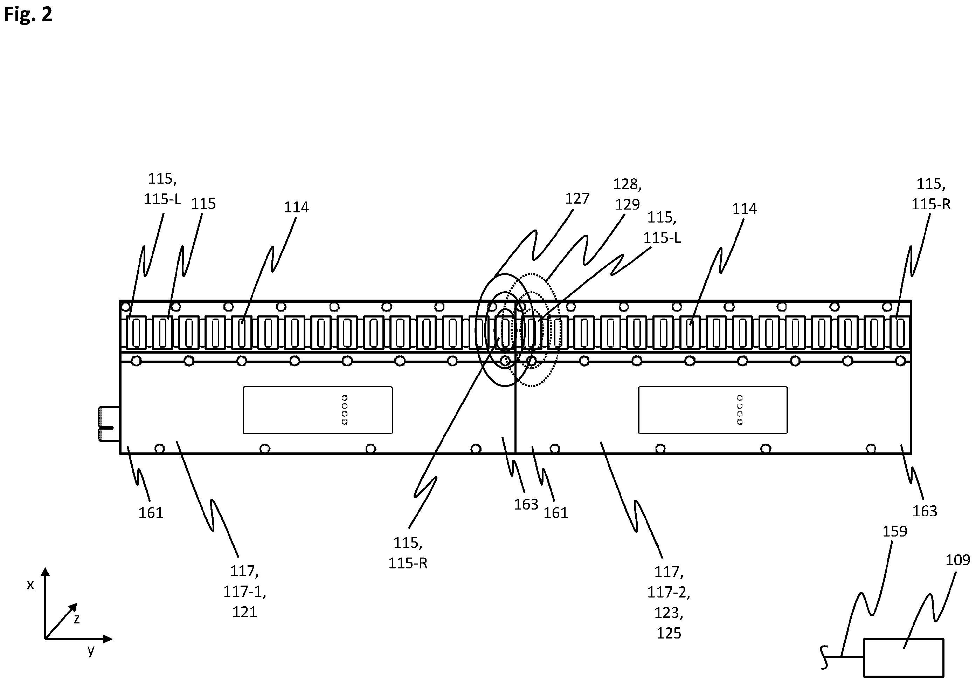

Fig. 2 zeigt eine weitere schematische Darstellung des linearen Transportsystems 100 aus Fig. 1. In Fig. 2 ist nur ein Ausschnitt, insbesondere nur zwei unmittelbar benachbarte Motormodule 117, der stationären Einheit 103 des linearen Transportsystems 100 dargestellt.

Um die Positionen der Motormodule 117 am Stator 111, sprich die Topologie des Stators 111 der beweglichen Einheit 103 zu ermitteln, ist die Steuereinheit 109 erfindungsgemäß eingerichtet, das erfindungsgemäße Verfahren zum Betreiben eines linearen Transportsystems 100 auszuführen. Bei Ausführung des Verfahrens zum Betreiben eines linearen Transportsystems wird durch die Steuereinheit 109 für jedes Motormodul 117 der Mehrzahl von Motormodulen 117 des Stators 111 ermittelt, ob zu dem jeweiligen Motormodul 117 ein unmittelbar benachbartes Motormodul 125 am Stator 111 angeordnet ist.

Hierzu wird aus der Mehrzahl von Motormodulen 117 ein Motormodul 117 als Testmotormodul 121 ausgewählt. In Fig. 2 sind vom Stator 111 ein erstes Motormodul 117-1 und ein zweites Motormodul 117-2 gezeigt. Rein beispielhaft ist zur Erläuterung des erfindungsgemäßen Verfahrens vorliegend das erste Motormodul 117-1 als Testmotormodul 121 ausgewählt.

Das Testmotormodul 121 ist hierbei ein beliebiges Motormodul 117 der Mehrzahl von Motormodulen 117 des Stators 111. Im Sinne der Anmeldung ist durch das Testmotormodul 121 dasjenige Motormodul 117 der Mehrzahl von Motormodulen 117 des Stators 111 gekennzeichnet, für das durch Ausführen des Verfahrens ermittelt wird, ob zu dem ausgewählten Testmotormodul 121 ein unmittelbar benachbartes Motormodul 125 existiert.

Hierzu wird das Testmotormodul 121 durch die Steuereinheit 109 angesteuert, durch wenigstens eine der Antriebsspulen 115 des Testmotormoduls 121 ein Testmagnetfeld 127 zu erzeugen. Das Testmagnetfeld 127 ist hierbei ein durch das als Testmotormodul 121 ausgewählte Motormodul 117 erzeugtes Magnetfeld.

In der gezeigten Ausführungsform weisen die Motormodule 117 jeweils eine Mehrzahl von Antriebsspulen 115 auf, die entlang der Längsachse LA des jeweiligen Motormoduls 117 zu einander beabstandet angeordnet sind. Die Motormodule 117-1, 117-2 weisen jeweils an einem ersten Ende 161 eine erste Randantriebsspule 115-L und an einem dem ersten Ende 161 gegenüberliegenden zweiten Ende 163 eine zweite Randantriebsspule 115-R auf.

Im gezeigten Beispiel wird das Testmagnetfeld 127 durch entsprechende Ansteuerung der am zweiten Ende 163 des als Testmotormodul 121 ausgewählten ersten Motormoduls 117-1 angeordneten zweiten Randantriebsspule 115-R erzeugt. Der Wirkbereich des durch die zweite Randantriebsspule 115-R erzeugten Testmagnetfelds 127 ist hierbei primär um das zweite Ende 163 des ersten Motormoduls 117-2 herum angeordnet.

Der Wirkbereich des Testmagnetfelds 127 ist hierbei als ein um die das Testmagnetfeld 127 erzeugende Antriebsspule 115 herum angeordneter Raumbereich definiert, in dem das Testmagnetfeld 127 mit weiteren Magnetfeldern oder mit einer magnetisierbaren und/oder elektrisch leitfähigen Komponente wechselwirken kann.

Alternativ oder zusätzlich kann zum Erzeugen des Testmagnetfelds 127 auch die am ersten Ende des ersten Motormoduls 117-1 angeordnete erste Randantriebsspule 115-L angesteuert werden.

Zum Ermitteln, ob zum Testmotormodul 121 ein weiteres Motormodul 117 unmittelbar benachbart angeordnet ist, wird erfindungsgemäß wenigstens ein weiteres Motormodul 117 des Stators 111 der stationären Einheit 103 als ein Störmotormodul 123 ausgewählt und angesteuert, eine Störgröße 128 zu erzeugen.

Im Folgenden wird die Störgröße 128 in Form eines Störmagnetfelds 129 in der Erläuterung des erfindungsgemäßen Verfahrens berücksichtigt. Das Ausgeben von Steuersignalen durch die Steuereinheit 109 zur Erzeugung der Störgröße 128 kann sowohl ein aktives Bestromen einer Antriebsspule 115 des als Störmotormoduls 123 ausgewählten Motormoduls 117 zur Erzeugung des jeweiligen Störmagnetfelds 129 als auch das Erzeugen einer Störgröße 128 in Form eines Kurzschlusses 132 einer Antriebsspule 115 des als Störmotormoduls 123 ausgewählten Motormoduls 117 beinhalten, wobei auch im Fall der Störgröße 128 in Form eines Kurzschlusses 132 passiv ein Störmagnetfeld 129 erzeugt wird.

Im gezeigten Beispiel wird das zweite Motormodul 117-2 als Störmotormodul 123 ausgewählt und entsprechend angesteuert, jeweils eine Störgröße 128 z. B. in Form eines Störmagnetfelds 129 zu erzeugen. Das Störmagnetfeld 129 ist hierbei das durch das als Störmotormodul 123 ausgewählte Motormodul 117 erzeugte Magnetfeld.

Zur besseren und einfacheren Darstellung sind in den Figuren von den Testmagnetfeldern 127 als auch den Störmagnetfeldern 129 ausschließlich die in der Bildebene angeordneten Feldkomponenten dargestellt. Die Testmagnetfelder 127 und Störmagnetfelder 129 können jedoch ebenfalls Feldkomponenten aufweisen, die senkrecht zur Bildebene orientiert sind. Diese senkrecht zur Bildebene orientierten Feldkomponenten können insbesondere stärker sein, als die dargestellten und parallel zur Bildebene verlaufenden Feldkomponenten.

Das Störmotormodul 123 ist analog zum Testmotormodul 121 ein gewöhnliches Motormodul 117 des Stators 111 und zeichnet sich dadurch aus, dass dieses zum Erzeugen des Störmagnetfelds 129 angesteuert wird. Das Störmagnetfeld 129 ist wiederum ein durch wenigstens eine Antriebsspule 115 des als Störmotormodul 123 ausgewählten Motormoduls 117 erzeugtes Magnetfeld.

Im gezeigten Beispiel wird das Störmagnetfeld 129 durch Bestromung der am ersten Ende 161 des zweiten Motormoduls 117-2 angeordneten ersten Randantriebsspule 115-L erzeugt. Ein Wirkbereich des Störmagnetfelds 129 ist hierbei primär im Bereich des ersten Endes 161 des zweiten Motormoduls 117-2 angeordnet.

Per Konvention kann beispielsweise festgelegt sein, dass die Testmagnetfelder 127 der als Testmotormodul 121 ausgewählten Motormodule 117 stets durch Bestromung der an den zweiten Enden 163 der jeweiligen Motormodule 117 angeordneten zweiten Randantriebsspulen 115-R erzeugt werden, und dass die Störmagnetfelder 129 der als Störmotormodule 123 ausgewählten Motormodule 117 stets durch Bestromung der an den ersten Enden 161 der jeweiligen Motormodule 117 angeordneten ersten Randantriebsspulen 115-L erzeugt werden.

Alternativ oder zusätzlich können die Testmagnetfelder 127 stets durch Bestromen der ersten Randantriebsspulen 115-L und die Störmagnetfelder 129 stets durch Bestromen der zweiten Randantriebsspulen 115-R der jeweils als Testmotormodul 121 oder Störmotormodul 123 ausgewählten Motormodule 117 erzeugt werden.

Werden Störmagnetfelder 129 durch mehr als ein Störmotormodul 123 erzeugt, so können diese mehreren Störmagnetfelder 129 zeitgleich oder zeitlich nacheinander erzeugt werden.

Zum Ermitteln, ob zu dem als Testmotormodul 121 ausgewählten ersten Motormodul 117-1 ein unmittelbar benachbartes Motormodul 125 existiert, wird nun überprüft, ob im Testmagnetfeld 127 des Testmotormoduls 121, sprich des ersten Motormoduls 117-1, eine durch das Störmagnetfeld 129 des Störmotormoduls 123, sprich des zweiten Motormoduls 117-2, verursachte Störung ermittelt wird.

Sind das Testmotormodul 121 und wenigstens ein Störmotormodul 123 unmittelbar benachbart zueinander angeordnet, sprich ist zwischen dem Testmotormodul 121 und dem Störmotormodul 123 kein weiteres Motormodul 117 angeordnet, kann eine Wechselwirkung zwischen dem Testmagnetfeld 127 und dem wenigstens einen Störmagnetfeld 129 erreicht werden. Diese Wechselwirkung kann wenigstens im Testmotormodul 121 in Form einer Störung des Testmagnetfelds 127 registriert werden.

Wird eine derartige durch das Störmagnetfeld 129 wenigstens eines Störmotormoduls 123 verursachte Störung des Testmagnetfelds 127 registriert und erreicht oder überschreitet die registrierte Störung des Testmagnetfelds 127 einen vordefinierten Grenzwert, so wird ein zum Testmotormodul 121 unmittelbar benachbartes Motormodul 125 ermittelt.

Im gezeigten Beispiel erfolgt eine Wechselwirkung zwischen dem Testmagnetfeld 127 des als Testmotormodul 121 ausgewählten ersten Motormoduls 117-1 mit dem Störmagnetfeld 129 des als Störmotormodul 123 ausgewählten zweiten Motormoduls 117-2 und durch die Wechselwirkung wird eine Störung des Testmagnetfelds 127 des Testmotormoduls 121 ermittelt, die den vordefinierten Grenzwert erreicht oder überschreitet.

Basierend auf der durch das Störmagnetfeld 129 des zweiten Motormoduls 117-2 erzeugten Störung des Testmagnetfelds 127 wird durch die Steuereinheit 109 ermittelt, dass unmittelbar benachbart zum zweiten Ende 163 des ersten Motormoduls 117-1 ein weiteres Motormodul 117 angeordnet ist.

Wären im gezeigten Beispiel das als Testmotormodul 121 ausgewählte erste Motormodul 117-1 und das als Störmotormodul 123 ausgewählte zweite Motormodul 117-2 hingegen weiter zueinander beabstandet, beispielsweise indem ein weiteres Motormodul 117 zwischen dem ersten Motormodul 117-1 und dem zweiten Motormodul 117-2 angeordnet wäre, so würden das Testmagnetfeld 127 des ersten Motormoduls 117-1 und das Störmagnetfeld 129 des zweiten Motormoduls 117-2 nicht miteinander wechselwirken und es würde durch das Störmagnetfeld 129 des zweiten Motormoduls 117-2 keine Störung im Testmagnetfeld 127 des ersten Motormoduls 117-1 erzeugt bzw. detektiert werden.

Auf der Tatsache, dass nach Bestromung der ersten Randantriebsspule 115-L des zweiten Motormoduls 117-2 im ersten Motormodul 117-1 keine Störung des Testmagnetfelds des ersten Motormoduls 117-1 detektiert würde, könnte ermittelt werden, dass das zweite Motormodul 117-2 nicht unmittelbar zum zweiten Ende 163 des ersten Motormoduls 117-1 benachbart angeordnet ist.

Wird das Testmagnetfeld 127 durch die erste Randantriebsspule 115-L des als Testmotormodul 121 ausgewählten ersten Motormoduls 117-1 erzeugt, so kann bei Ermittlung einer Störung des Testmagnetfelds 127 durch ein Störmagnetfeld 129 eines anderen Motormoduls 117 als dem hier gezeigten zweiten Motormodul 117-2 so kann auf der ermittelten Störung des Testmagnetfelds 127 basierend ein weiteres zum ersten Motormodul 117-1 unmittelbar benachbartes Motormodul 125 ermittelt werden, wobei dieses weitere unmittelbar benachbarte Motormodul zum ersten Ende 161 des ersten Motormoduls 117-1 benachbart angeordnet wäre.

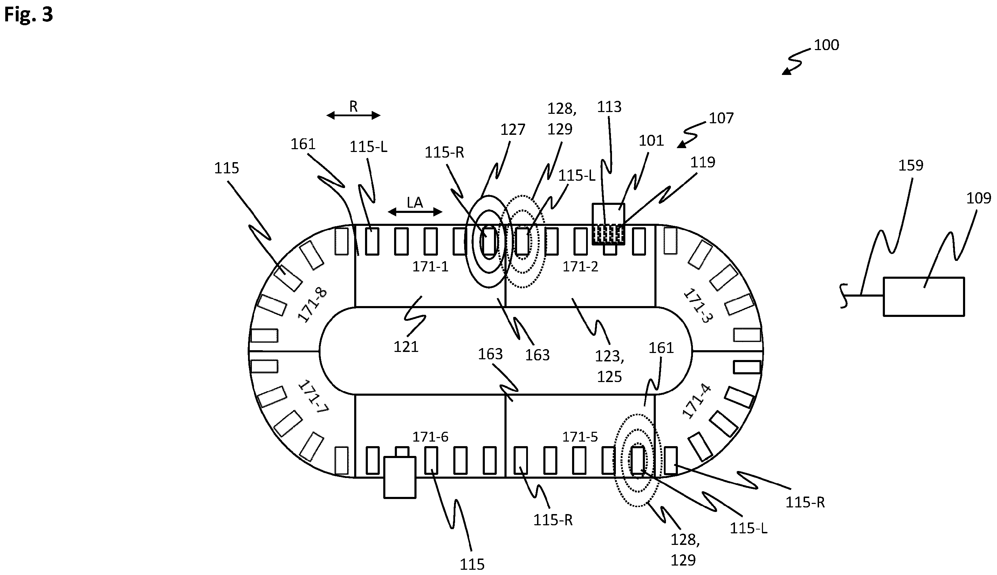

Fig. 3 zeigt eine weitere schematische Darstellung des linearen Transportsystems 100 aus Fig. 1. In Fig. 3 ist eine Mehrzahl von Motormodulen 117 des Stators 111 der stationären Einheit 103 dargestellt. In einem Rundkurs sind acht Motormodule 117-1,..., 117-8 dargestellt.

Zur Illustration weiterer Schritte des erfindungsgemäßen Verfahrens ist das erste Motormodul 117-1 wiederum als Testmotormodul 121 ausgewählt. Analog zur Fig. 2 wird wiederum die zweite Randantriebsspule 115-R des ersten Motormoduls 117-1 zum Erzeugen des Testmagnetfelds 127 bestromt.

Um zu ermitteln, ob und welche Motormodule 117 zum als Testmotormodul 121 ausgewählten ersten Motormodul 117-1 benachbart angeordnet sind, wird nun eine Mehrzahl von Motormodulen 117 als Störmotormodul 123 zum Erzeugen von Störmagnetfeldern 129 ausgewählt. Im gezeigten Beispiel werden das zweite Motormodul 117-2 und das fünfte Motormodul 117-5 als Störmotormodule 123 ausgewählt.

Zum Zeitpunkt der Ausführung des Verfahrens ist die Reihenfolge der Motormodule 117 entlang der stationären Einheit 103 der Steuereinheit 109 wenigstens teilweise unbekannt. Sowohl als Testmotormodule 121 aber auch als Störmotormodule 123 werden beliebige Motormodule 117 der stationären Einheit 103 ausgewählt.

Der Konvention der Ausführungsform in Fig. 2 folgend werden in der gezeigten Ausführungsform zum Erzeugen der Störmagnetfelder 129 jeweils die ersten Randantriebsspulen 115-L der als Störmotormodule 123 ausgewählten zweiten und fünften Motormodule 117-2, 117-5 bestromt.

Analog zur Ausführungsform in Fig. 2 ist in Fig. 3 das zweite Motormodul 117-2 unmittelbar zum zweiten Ende 163 des als Testmotormodul 121 ausgewählten ersten Motormoduls 117-1 angeordnet. Das Testmagnetfeld 127 des ersten Motormoduls 117-1 erfährt damit durch Wechselwirkung mit dem Störmagnetfeld 129 des zweiten Motormoduls 117-2 eine Störung. Aufgrund der Störung des Testmagnetfelds 127 wird somit erfindungsgemäß das zweite Motormodul 117-2 als unmittelbar benachbartes Motormodul 125 zum ersten Motormodul 117-1 ermittelt. Da im ersten Motormodul 117-1 nur die zweite Randantriebsspule 115-R zum Erzeugen des Testmagnetfelds 127 bestromt ist, kann durch die ermittelte Störung des Testmagnetfelds 127 durch das Störmagnetfeld 129 des zweiten Motormoduls 117-2 das zweite Motormodul 117-2 als unmittelbar zum zweiten Ende 163 des ersten Motormoduls 117-1 benachbart angeordnet ermittelt werden.

Da das fünfte Motormodul 117-5 nicht unmittelbar zum ersten Motormodul 117-1 benachbart angeordnet ist, kann keine Wechselwirkung zwischen dem Störmagnetfeld 129 des fünften Motormoduls 117-5 und dem Testmagnetfeld 127 des ersten Motormoduls 117-1 erzielt werden. Das Störmagnetfeld 129 des fünften Motormoduls 117-5 führt somit zu keiner Störung des Testmagnetfelds 127 des ersten Motormoduls 117-1.

Werden die beiden ersten Randantriebsspulen 115-L des zweiten Motormoduls 117-2 und des fünften Motormoduls 117-5 zeitgleich zum Erzeugen der Störmagnetfelder 129 bestromt, so kann durch Ermittlung der Störung des Testmagnetfelds 127 des ersten Motormoduls 117-1 nur ermittelt werden, dass zum zweiten Ende 163 des ersten Motormoduls 117-1 ein unmittelbar benachbartes Motormodul 125 angeordnet ist. Es kann jedoch nicht entschieden werden, ob dieses unmittelbar benachbarte Motormodul 125 das zweite Motormodul 117-2 oder das fünfte Motormodul 117-5 ist.

Werden die beiden ersten Randantriebsspulen 115-L des zweiten Motormoduls 117-2 und des fünften Motormoduls 117-5 hingegen zeitlich nacheinander bestromt und die zwei Störmagnetfelder 129 somit ebenfalls zeitlich nacheinander und ohne zeitliche Überschneidung erzeugt, so kann basierend auf der ermittelten Störung des Testmagnetfelds 127 das zweite Motormodul 117-2 als das zum zweiten Ende 163 des ersten Motormoduls 117-1 unmittelbar benachbarte Motormoduls 125 identifiziert werden.

Da durch das Störmagnetfeld 129 des fünften Motormoduls 117-5 keine Störung des Testmagnetfelds 127 des ersten Motormoduls 117-1 erzeugt wird, kann im gezeigten Aufbau aus der Erzeugung des Störmagnetfelds 129 durch das fünfte Motormodul 117-5 nur ermittelt werden, dass das fünfte Motormodul 117-5 nicht unmittelbar neben dem zweiten Ende 163 des ersten Motormoduls 117-1 angeordnet ist. An welcher Stelle das fünfte Motormodul 117-5 am Stator 111 der stationären Einheit 103 angeordnet ist, kann hingegen nicht ermittelt werden.

Alternativ zu den zwei Motormodulen 117, die im gezeigten Beispiel als Störmotormodule 123 die Störmagnetfelder 129 erzeugen, kann auch eine größere Anzahl von Motormodulen 117 zum Erzeugen von Störmagnetfeldern 129 angesteuert werden. Werden die mehreren Motormodule 117 insbesondere zeitlich nacheinander zum Erzeugen der Störmagnetfelder 129 angesteuert, kann mit der Ansteuerung abgebrochen werden, sobald eine Störung des Testmagnetfelds 127 des als Testmotormodul 121 ausgewählten Motormoduls 117 ermittelt wird.

Zum Ermitteln des zum ersten Ende 161 des als Testmotormodul 121 ausgewählten ersten Motormoduls 117-1 unmittelbar benachbarten Motormoduls 125 kann zum Erzeugen des Testmagnetfelds 127 die erste Randantriebsspule 115-L bestromt werden und mit dem oben beschrieben Verfahren fortgesetzt werden.

Zum Ermitteln der vollständigen Topologie kann das obige Verfahren derart fortgesetzt werden, dass nacheinander jedes der Motormodule 117 des Stators 111 der stationären Einheit 103 als Testmotormodul 121 zum Erzeugen des Testmagnetfelds 127 ausgewählt wird, wobei die jeweils anderen Motormodule 117 als Störmotormodule 123 die Störmagnetfelder 129 erzeugen.

Alternativ können alle Motormodule 117 des Stators 111 der stationären Einheit 103 als Testmotormodule 121 ausgewählt werden und jeweils die zweiten Randantriebsspulen 115-R der ausgewählten Motormodule 117 zum Erzeugen der Testmagnetfelder 127 bestromt werden. Ferner können in allen Motormodulen 117 des Stators 111 der stationären Einheit 103 die ersten Randantriebsspulen 115-L zum Erzeugen der Störmagnetfelder 129 bestromt werden.

Die Motormodule 117 dienen somit mit ihren zweiten Randantriebsspulen 115-R, mit denen die Testmagnetfelder 127 erzeugt werden, als Testmotormodule 121 und mit ihren ersten Randantriebsspulen 115-L, mit denen die Störmagnetfelder 129 erzeugt werden, gleichzeitig als Störmotormodule 123.

Hierbei können entweder alle zweiten Randantriebsspulen 115-R der Motormodule 117 zum Erzeugen der Testmagnetfelder 127 gleichzeitig bestromt und die ersten Randantriebsspulen 115-L der Motormodule 117 zeitlich nacheinander und einzeln zum Erzeugen der Störmagnetfelder bestromt werden.

Alternativ können die zweiten Randantriebsspulen 115-R der Motormodule 117 zum Erzeugen der Testmagnetfelder 127 zeitlich nacheinander und einzeln bestromt und die ersten Randantriebsspulen 115-L der Motormodule 117 des Stators 111 gleichzeitig zum Erzeugen der Störmagnetfelder 129 bestromt werden.

Die Testmagnetfelder 127 werden hierbei derart zeitlich nacheinander erzeugt, dass keine zeitliche Überschneidung zwischen zwei Testmagnetfeldern 127 besteht. Analog werden die Störmagnetfelder 129 derart zeitlich nacheinander erzeugt, dass keine zeitliche Überschneidung zwischen zwei Störmagnetfeldern 129 besteht.

Indem alle Motormodule 117 durch die zweiten Randantriebsspulen 115-R die Testmagnetfelder 127 und durch die ersten Randantriebsspulen 115-L die Störmagnetfelder 129 erzeugt werden, kann für jedes Motormodul 117 ein zum zweiten Ende 163 unmittelbar benachbartes Motormodul 125 ermittelt werden, falls im Stator 111 ein solches Motormodul 117 angeordnet ist. Indem dies für alle Motormodule 117 durchgeführt wird, kann so die vollständige Topologie des Stators 111 der statischen Einheit 103 ermittelt werden.

Wird für ein als Testmotormodul 121 ausgewähltes Motormodul 117 hingegen keine Störung des Testmagnetfelds 127 durch ein Störmagnetfeld 129 wenigstens eines der weiteren Motormodule 117 ermittelt, so wird erkannt, dass zum zweiten Ende 163 des jeweiligen Motormoduls 117 kein unmittelbar benachbartes Motormoduls 125 angeordnet ist.

Alternativ können zum Erzeugen der Testmagnetfelder 127 die ersten Randantriebsspulen 115-L und zum Erzeugen der Störmagnetfelder 129 die zweiten Randantriebsspulen 115-R der Motormodule 117 bestromt werden. Das Verfahren wird hierbei analog ausgeführt.

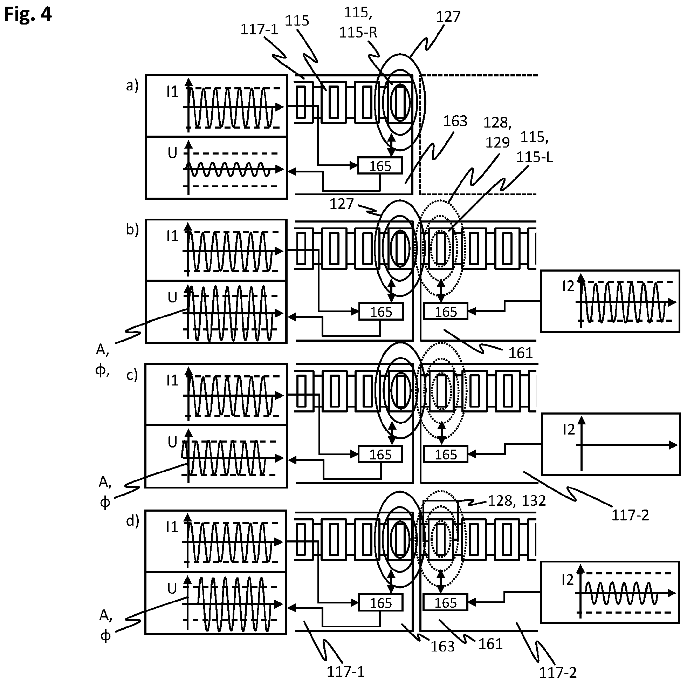

Fig. 4 zeigt eine grafische Darstellung von Verfahrensschritten eines Verfahrens zum Betreiben eines linearen Transportsystems 100.

In den Graphiken a) bis d) sind verschiedene Schritte bzw. Ausführungsformen des oben bereits beschriebenen Verfahrens zum Betreiben eines linearen Transportsystems 100 graphisch dargestellt. Hierzu sind in den Graphiken b) bis d) ein erstes Motormodul 117-1 und ein zweites Motormodul 117-2 dargestellt. das erste Motormodul 117-1 und das zweite Motormodul 117-2 sind nur teilweise dargestellt. Von beiden Motormodulen 117-1, 117-2 sind mehrere Antriebsspulen 115 gezeigt. Insbesondere sind vom ersten Motormodul 117-1 die am zweiten Ende 163 angeordnete zweite Randantriebsspule 115-R und vom zweiten Motormodul 117-2 die am ersten Ende 161 angeordnete erste Randantriebsspule 115-L gezeigt.

Analog zu dem in Figur 1 bis 3 beschriebenen Verfahren sind nun das erste Motormodul 117-1 als ein Testmotormodul 121 und das zweite Motormodul 117-2 als ein Störmotormodul 123 ausgewählt. Zum Bestimmen der unmittelbar zum als Testmotormodul 121 ausgewählten ersten Motormodul 117-1 benachbart angeordneten Motormodule 117 ist nun die zum zweiten Ende 163 benachbart angeordnete zweite Randantriebsspule 115-R des ersten Motormoduls 117-1 zum Erzeugen des Testmagnetfelds 127 angesteuert. Entsprechend ist in den Graphiken b) bis d) die zum ersten Ende 161 des zweiten Motormoduls 117-2 benachbart positionierte erste Randantriebsspule 115-L des als Störmotormodul 123 ausgewählten zweiten Motormoduls 117-2 zum Erzeugen der Störgröße 128 angesteuert.

In der gezeigten Ausführungsform der Graphiken a) bis d) ist die zweite Antriebsspule 115-R des ersten Motormoduls 117-1 zum Erzeugen des Testmagnetfelds 127 mit einem sinus- bzw. kosinusförmigen ersten Betriebsstrom I1 bestromt.

In Graphik a) ist der Fall dargestellt, dass benachbart zum zweiten Ende 163 des ersten Motormoduls 117-1 kein weiteres Motormodul 117 angeordnet ist. Das durch die zweite Randantriebsspule 115-R des ersten Motormoduls 117-1 erzeugte Testmagnetfeld 127 erfährt somit keine auf einer Störgröße 128 eines weiteren Motormoduls 117 basierende Störung. Die entsprechend an der zweiten Randantriebsspule 115-R anliegende Betriebsspannung U weist somit einen entsprechend ungestörten sinus- bzw. kosinusförmigen Verlauf auf. Wird ein solcher Verlauf der Betriebsspannung U in einem der Motormodule 117 nach gleichzeitigem Bestromen aller Motormodule 117 als Störmotormodul 123 festgestellt, kann daraus geschlussfolgert werden, dass das als Testmotormodul 121 ausgewählte Motormodul 117-1 kein unmittelbar benachbartes Modul am zweiten Ende 163 aufweist.

In den Graphiken b) bis d) ist der Fall dargestellt, dass in Richtung des zweiten Endes 163 des ersten Motormoduls 117-1 das zweite Motormodul 117-2 als unmittelbar benachbartes Motormodul 125 angeordnet ist. Durch die Ansteuerung der ersten Randantriebsspule 115-L des als Störmotormodul 123 ausgewählten zweiten Motormoduls 117-2 und die entsprechend erzeugte Störgröße 128, die mit dem Testmagnetfeld 127 des ersten Motormoduls 117-1 wechselwirkt, erfährt das Testmagnetfeld 127 eine entsprechende Störung.

Die Störung kann im ersten Motormodul 117-1 durch eine entsprechende Änderung der an der entsprechend angesteuerten zweiten Randantriebsspule 115-R abfallenden Betriebsspannung U detektiert werden. Die entsprechend detektierte Spannungsänderung kann sowohl die Spannungsamplitude A als auch die Spannungsphase φ der Betriebsspannung U umfassen.

Die Spannungsänderung der Betriebsspannung U kann im als Testmotormodul 121 ausgewählten ersten Motormodul 117-1 beispielsweise durch eine Reglereinheit 165 detektiert werden, die eingerichtet ist, den Aufbau des Testmagnetfelds 127 durch Ansteuerung der zweiten Randantriebsspule 115-R zu regeln.

In Graphik b) wird die erste Randantriebsspule 115-L des zweiten Motormoduls 117-2 mit einem sinus- bzw. kosinusförmigen zweiten Betriebsstrom I2 beaufschlagt. Bei einer Beaufschlagung der ersten Randantriebsspule 115-L des zweiten Motormoduls 117-2 mit einem sinus- bzw. kosinusförmigen zweiten Betriebsstrom I2 wird eine Störgröße 128 in Form eines Störmagnetfelds 129 erzeugt.

In Graphik c) wird die erste Randantriebsspule 115-L des zweiten Motormoduls 117-2 zum Erzeugen der Störgröße 128 mit einem Nullstrom als zweiten Betriebsstrom I2 beaufschlagt. Zur Beaufschlagung der ersten Randantriebsspule 115-L mit einem Nullstrom als zweiten Betriebsstrom I2 ist ein Ausgleichsstrom notwendig, der einem durch das Testmagnetfeld 127 induzierten Strom bzw. einer durch das Testmagnetfeld 127 induzierten Spannung an der ersten Randantriebsspule 115-L des Störmotormoduls 123 entgegenwirkt. Dabei wird eine Störgröße 128 in Form eines Störmagnetfelds 129 erzeugt.

Die unterschiedliche Bestromung in b) und c) führt gegebenenfalls zu unterschiedlichen Störgrößen 128, die zu unterschiedlichen Störungen des Testmagnetfelds 127 führen können.

In Graphik d) wird alternativ zu der aktiven Bestromung der ersten Randantriebsspule 115-L des zweiten Motormoduls 117-2 zum Erzeugen der Störgröße 128 in Form eines Störmagnetfelds 128 die erste Randantriebsspule 115-L des zweiten Motormoduls 117-2 aufgrund von Steuersignalen der Steuereinheit 109 in einen Kurzschlusszustand geschaltet, wobei eine Störgröße 128 in Form eines Kurzschlusses 132 erzeugt wird. Dabei ist der aufgrund von Steuersignalen 109 ausgeführte aktive Schritt das Kurzschließen der ersten Randantriebsspule 115-L des zweiten Motormoduls 117-2 und nicht das Bestromen dieser, sodass der Kurzschluss 132 die Störgröße 128 ist.

Auch bei der Störgröße (128) in Form eines Kurzschlusses (132) wird passiv ein Störmagnetfeld (129) erzeugt. Mit passiv ist dabei gemeint, dass das Störmagnetfeld nicht durch aktive Bestromung der ersten Randantriebsspule 115-L des zweiten Motormoduls 117-2 erzeugt wird. Durch Wechselwirkung des Testmagnetfelds 127 des als Testmotormodul 121 ausgewählten ersten Motormoduls 117-1 mit der kurzgeschlossenen ersten Randantriebsspule 115-L des als Störmotormodul 123 ausgewählten zweiten Motormoduls 117-2 kann in der kurzgeschlossenen ersten Randantriebsspule 115-L durch das Testmagnetfeld 127 eine Spannung bzw. ein Strom induziert werden, durch die/den die kurzgeschaltete erste Randantriebsspule 115-L des zweiten Motormoduls 117-2 ein entsprechendes Störmagnetfeld 129 generiert. Hierdurch kann durch Induktion das Störmagnetfeld 129 automatisch durch Wechselwirkung der entsprechenden Antriebsspule 115 mit dem Testmagnetfeld 127 passiv generiert werden, ohne dass hierzu eine aktive Bestromung der jeweiligen Antriebsspule 115 des Störmotormoduls 123 zur Erzeugung des Störmagnetfelds (129) benötigt würde.

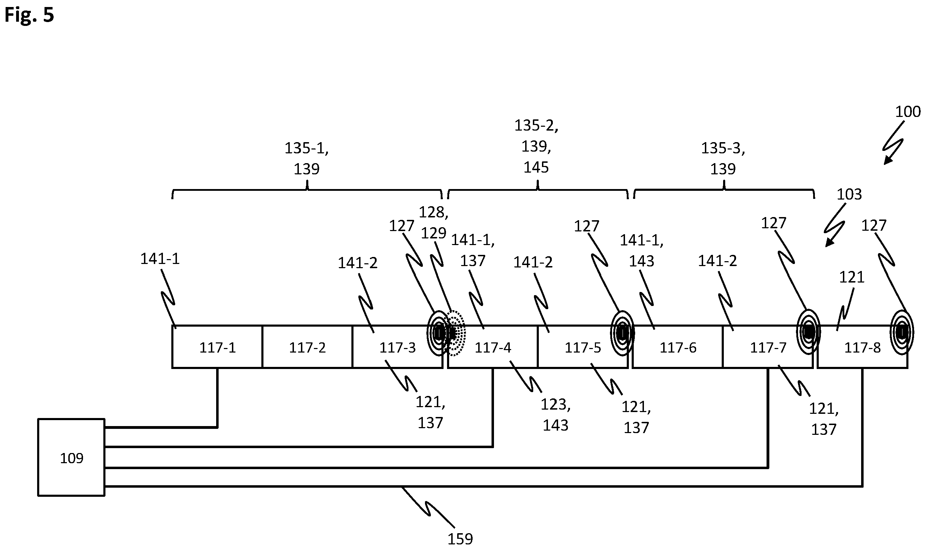

Fig. 5 zeigt eine weitere schematische Darstellung des linearen Transportsystems 100 gemäß einer weiteren Ausführungsform.

In der gezeigten Ausführungsform sind die Motormodule 117 des Stators 111 in Motormodulstränge 135 zusammengefasst. In einem Motormodulstrang 135 sind im Sinne der Anmeldung wenigstens zwei Motormodule 117 ausgebildet und leitungsgebunden miteinander verbunden. In der beispielhaften Ausführungsform sind acht Motormodule 117, ein erstes Motormodul 117-1, ein zweites Motormodul 117-2, ein drittes Motormodul 117-3, ein viertes Motormodul 117-4, ein fünftes Motormodul 117-5, ein sechstes Motormodul 117-6, ein siebtes Motormodul 117-7 und ein achtes Motormodul 117-8 in einen ersten Motormodulstrang 135-1, einen zweiten Motormodulstrang 135-2 und einen dritten Motormodulstrang 135-3 zusammengefasst. Im ersten Motormodulstrang 135-1 sind das erste bis dritte Motormodul 117-1, 117-3 zusammengefasst. Im zweiten Motormodulstrang 135-2 sind das vierte und fünfte Motormodul 117-4, 117-5 zusammengefasst. Im dritten Motormodulstrang 135-3 sind das sechste und siebte Motormodul 117-6, 117-7 zusammengefasst. Das achte Motormodul 117-8 ist als eigenständiges Motormodul dargestellt.

Die ersten bis dritten Motormodulstränge 135-1, 135-2, 135-3 sind durch entsprechende Datenleitungen 159 mit der Steuereinheit 109 verbunden. Jeder Motormodulstrang 135-1, 135-2, 135-3 weist jeweils ein erstes Randmotormodul 141-1 und ein zweites Randmotormodul 141-2 auf. Die ersten und zweiten Randmotormodule 141-1, 141-2 von zwei entlang der Führungsschiene 105 unmittelbar benachbart zueinander angeordneten Motormodulsträngen 135 sind zueinander benachbart angeordnet. Um die einzelnen Positionierungen der verschiedenen Motormodulstränge 135 zueinander bestimmen zu können, werden gemäß dem erfindungsgemäßen Verfahren wenigstens ein Motormodulstrang 135 als Testmotormodulstrang 139 und ein weiterer Motormodulstrang 135 als Störmotormodulstrang 145 ausgewählt.

In der gezeigten Ausführungsform werden alle als Testrandmotormodule 137 ausgewählten zweiten Randmotormodule 141-2 der gezeigten Motormodulstränge 135 gleichzeitig zum Erzeugen der Testmagnetfelder 127 angesteuert. Analog zu den Ausführungsformen der Fig. 2, 3 werden hierzu die an den zweiten Enden 163 der zweiten Randmotormodule 141-2 angeordneten zweiten Randantriebsspulen 115-R bestromt. Als Störrandmotormodule 143 werden zeitlich nacheinander alle ersten Randmotormodule 141-1 der verschiedenen Motormodulstränge 135 zum Erzeugen der Störmagnetfelder 129 angesteuert.

Wiederum den obigen Ausführungsformen entsprechend werden hierzu die an den ersten Enden 161 der ersten Randmotormodule 141-1 angeordneten ersten Randantriebsspulen 115-L angesteuert. In Fig. 5 ist ausschließlich gezeigt, dass das erste Randmotormodul 141-1 des zweiten Motormodulstrangs 135-2 zum Erzeugen des jeweiligen Störmagnetfelds 129 angesteuert wird. Die ersten Randmotormodule 141-1 der weiteren Motormodulstränge 135 können entsprechend zu anderen Zeitpunkten zum Erzeugen der jeweiligen Störmagnetfelder 129 angesteuert.

Entsprechend der Ausführungsform in Fig. 3 können die als Testrandmotormodule 137 ausgewählten zweiten Randmotormodule 141-2 zeitgleich zum Erzeugen der Testmagnetfelder 127 und die als Störrandmotormodule 143 ausgewählten ersten Randmotormodule 141-1 zeitlich nacheinander zum Erzeugen der Störmagnetfelder 129 angesteuert werden.

Alternativ können die als Testrandmotormodule 137 ausgewählten zweiten Randmotormodule 141-2 zeitlich nacheinander zum Erzeugen der Testmagnetfelder 127 und die als Störrandmotormodule 143 ausgewählten ersten Randmotormodule 141-1 zeitgleich zum Erzeugen der Störmagnetfelder 129 angesteuert werden.

In einer weiteren Ausführungsform ist der zweite Motormodulstrang 135-2 als Testmotormodulstrang 139 ausgewählt. Der erste Motormodulstrang 135-1 und der dritte Motormodulstrang 135-3 sind als entsprechende Störmotormodulstränge 145 ausgewählt. Zum Bestimmen der unmittelbar zum als Testmotormodulstrang 139 ausgewählten zweiten Motormodulstrang 135-2 benachbart angeordneten Motormodulstränge 135 werden die beiden Randmotormodule 141-1, 141-2, sprich das vierte Motormodul 117-4 und das fünfte Motormodul 117-5 des zweiten Motormodulstrangs 135-2 als Testrandmotormodule 137 des Testmotormodulstrangs 139 zum Generieren entsprechender Testmagnetfelder 127 ausgewählt und angesteuert.

Ferner werden im ersten Motormodulstrang 135-1 das dritte Motormodul 117-3 als Störrandmotormodul 143 und im dritten Motormodulstrang 135-3 das sechste Motormodul 117-6 als weiteres Störrandmotormodul 143 der jeweiligen Störmotormodulstränge 145 zum Erzeugen der Störmagnetfelder 129 ausgewählt und angesteuert.

Nach Erzeugung der Testmagnetfelder 127 durch die Testrandmotormodule 137 des als Testmotormodulstrang 139 ausgewählten zweiten Motormodulstrangs 135-2 und nach Erzeugung der entsprechenden Störmagnetfelder 129 der Störrandmotormodule 143 der als Störmotormodulstränge 145 ausgewählten ersten und dritten Motormodulstränge 135-1, 135-3 können gemäß den oben beschriebenen Verfahrensschritten bei Ermittlung von Störungen der Testmagnetfelder 127 die ersten und dritten Motormodulstränge 135-1, 135-3 zum zweiten Motormodulstrang 135-2 als direkt benachbarte Motormodulstränge 135 identifiziert werden.

Nach Auswahl der jeweiligen Testrandmotormodule 137 bzw. Störrandmotormodule 143 der jeweiligen Testmotormodulstränge 139 bzw. Störmotormodulstränge 145 verläuft das Verfahren analog zu den oben beschriebenen Verfahrensschritten. Im Falle der Ausbildung der Motormodule 117 des Stators 111 in Motormodulsträngen 135 ist zu der Ausführungsform der Figur 1, in der die Motormodule 117 als eigenständige Motormodule ausgebildet sind, lediglich der Unterschied vorhanden, dass zur Ermittlung der vollständigen Topologie des linearen Transportsystems 100 als Testmotormodule 121 bzw. Störmotormodule 123 ausschließlich die Randmotormodule 141-1, 141-2 der jeweiligen Motormodulstränge 135 ausgewählt werden.

Da die Motormodule 117 eines gemeinsamen Motormodulstrangs 135 leitungsgebunden miteinander verbunden sind, sind die einzelnen Positionierungen der Motormodule 117 innerhalb der Motormodulstränge 135 der Steuereinheit 109 bereits bekannt. Lediglich die Positionierung der einzelnen Motormodulstränge 135 am Stator 111, sprich die relative Positionierung der verschiedenen Motormodulstränge 135 zueinander, ist der Steuereinheit 109 zum Zeitpunkt der Ausführung des erfindungsgemäßen Verfahrens unbekannt. Um die relative Positionierung der einzelnen Motormodulstränge 135 im Stator 111 zueinander zu ermitteln, sind somit ausschließlich die Randmotormodule 141-1, 141-2 der verschiedenen Motormodulstränge 135 gemäß dem erfindungsgemäßen Verfahren zu berücksichtigen.

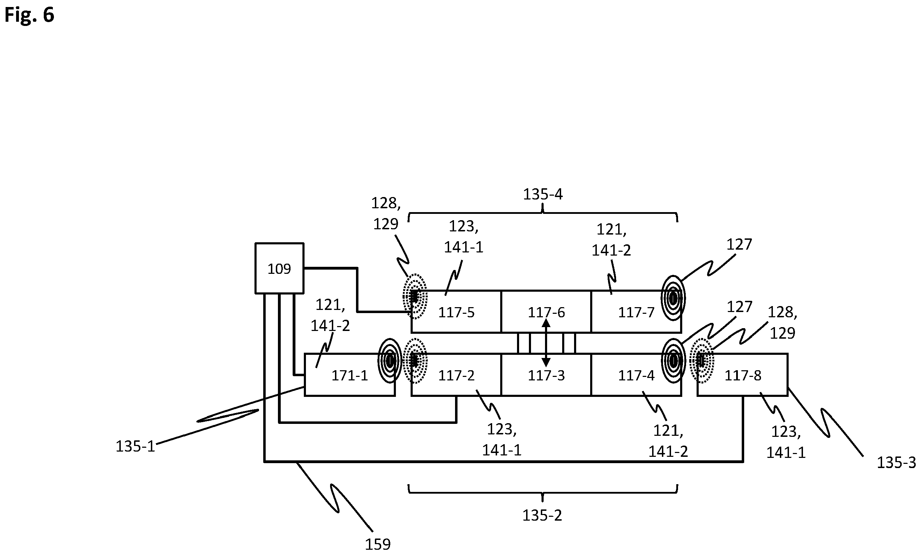

Fig. 6 zeigt eine weitere schematische Darstellung des linearen Transportsystems 100 gemäß einer weiteren Ausführungsform.

In der gezeigten Ausführungsform sind die Motormodule 117 des Stators 111 in vier Motormodulstränge 135 zusammengefasst. Ein erster Motormodulstrang 135-1, ein zweiter Motormodulstrang 135-2 und ein dritter Motormodulstrang 135-3 sind entlang der Längsachse LA hintereinander angeordnet. Ein vierter Motormodulstrang 135-4 ist parallel zum zweiten Motormodulstrang 135-2 dargestellt und in einem Weichenmodul 167 mit dem zweiten Motormodulstrang 135-2 zusammengefasst.

Zwecks Übersichtlichkeit sind vom ersten Motormodulstrang 135-1 und vom dritten Motormodulstrang 135-3 jeweils nur ein Motormodul 117 dargestellt. Dies soll jedoch nicht einschränkend wirken.

In Abhängigkeit der Stellung des Weichenmoduls 167 kann der erste Motormodulstrang 135-1 mit dem zweiten Motormodulstrang 135-2 oder dem vierten Motormodulstrang 135-4 verbunden sein. In Abhängigkeit der Stellung des Weichenmoduls 167 kann somit eine bewegliche Einheit 101 von dem ersten Motormodulstrang 135-1 entlang dem zweiten Motormodulstrang 135-2 oder entlang dem vierten Motormodulstrang 135-4 bewegt werden.

Durch Ausführung des zur Ausführungsform der Figur 5 beschriebenen Verfahrens durch Bestromung der zweiten Randmotormodule 141-2 aller Motormodulstränge 135 zum Erzeugen der Testmagnetfelder 127 und durch das entsprechende Bestromen aller ersten Randmotormodule 141-1 zum Erzeugen der entsprechenden Störmagnetfelder 129 können zu jedem zweiten Randmotormodul 141-2 eines Motormodulstrangs 135 das jeweils benachbarte erste Randmotormodul 141-1 des jeweils benachbarten Motormodulstrangs 135, falls vorhanden, ermittelt werden.

In dem vorliegenden Beispiel kann somit bei Kenntnis, dass der zweite Motormodulstrang 135-2 und der vierte Motormodulstrang 135-4 im Weichenmodul 167 angeordnet sind, die Stellung des Weichenmoduls 167 ermittelt werden.

Im vorliegenden Beispiel wird durch Ausführung des genannten Verfahrens ermittelt, dass das erste Motormodul 117-1, welches Teil des ersten Motormodulstrangs 135-1 ist, und das zweite Motormodul 117-2, welches Teil des zweiten Motormodulstrangs 135-2 ist, zueinander unmittelbar benachbart angeordnet sind. Entsprechend wird somit ermittelt, dass der erste Motormodulstrang 135-1 und der zweite Motormodulstrang 135-2 unmittelbar benachbart zueinander angeordnet sind. Hierauf basierend kann die jeweilige Stellung des Weichenmoduls 167 ermittelt werden.

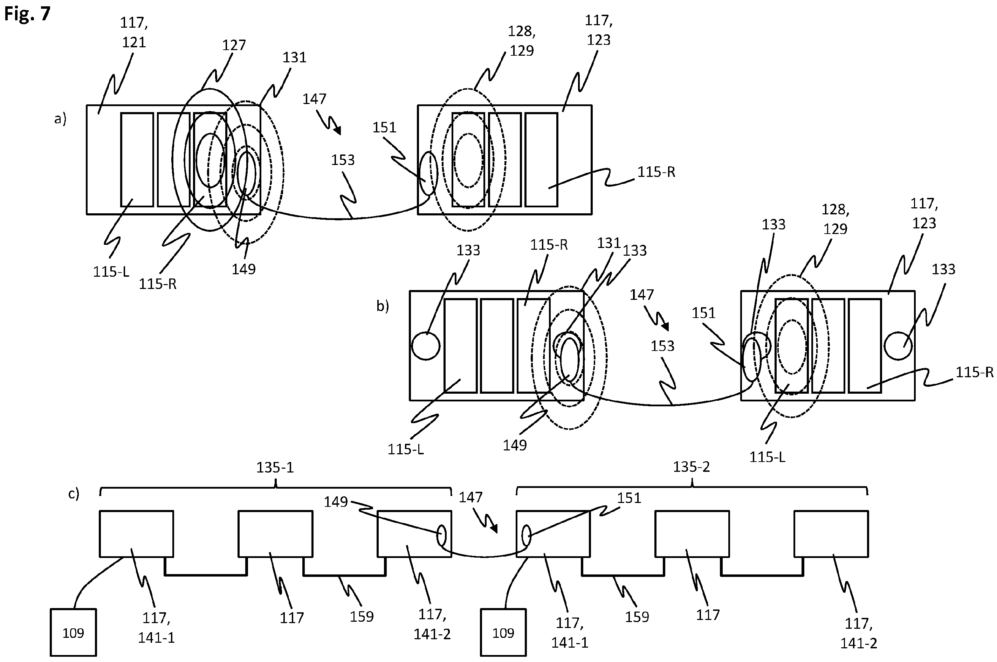

Fig. 7 zeigt eine weitere schematische Darstellung des linearen Transportsystems 100 gemäß einer weiteren Ausführungsform.

In der gezeigten Ausführungsform umfasst das lineare Transportsystem 100 ferner eine Signalübertragungseinrichtung 147 mit einem ersten Übertragungselement 149 und einem zweiten Übertragungselement 151, die über eine Verbindungsleitung 153 miteinander verbunden sind.

In Graphik a) sind zwei Motormodule 117 gemäß den oben beschriebenen Ausführungsformen mit Antriebsspulen 115 dargestellt. Die Motormodule 117 sind durch einen Spalt 155 voneinander getrennt. Die Signalübertragungseinrichtung 147 ist jeweils mit dem ersten Übertragungselement 149 am ersten Motormodul 117-1 und mit dem zweiten Übertragungselement 151 am zweiten Motormodul 117-2 angeordnet. Über die beiden Übertragungselemente 149, 151 kann ein durch die Störgröße 128 des als Störmotormodul 123 ausgewählten zweiten Motormoduls 117-2 verursachtes magnetisches Störsignal 131 in den Wirkbereich des Testmagnetfelds 127 des als Testmotormodul 121 ausgewählten ersten Motormoduls 117-1 übertragen werden.

Durch den Spalt 155 zwischen den beiden Motormodulen 117 ist eine Wirkung der Störgröße 128 auf des Testmagnetfelds 127 gegebenenfalls zu gering, als dass eine durch die Störgröße 128 im Testmagnetfeld 127 hervorgerufene Störung registrierbar wäre bzw. den vordefinierten Grenzwert erreichte oder überschritt.

Durch die Übertragung des magnetischen Störsignals 131 der Störgröße 128 in den Wirkbereich des Testmagnetfelds 127 durch die Signalübertragungseinrichtung 147 kann hingegen dennoch eine durch die Störgröße 128 verursachte Störung des Testmagnetfelds 127 registriert und das als Störmotormodul 123 ausgewählte zweite Motormodul 117-2 als unmittelbar benachbartes Motormodul 125 zum ersten Motormodul 117-1 identifiziert werden.

Gemäß einer Ausführungsform sind die ersten und zweiten Übertragungselemente 149, 151 als Übertragungsspulen ausgebildet. In der im Wirkbereich der Störgröße 128 angeordneten Übertragungsspule des zweiten Übertragungselements 151 kann mittels Induktion durch die Störgröße 128 eine entsprechende induzierte Spannung bzw. ein induzierter Strom erzeugt werden. In der mit der Übertragungsspule des zweiten Übertragungselements 151 verbundenen Übertragungsspule des ersten Übertragungselements 149 kann durch die in der Übertragungsspule des zweiten Übertragungselements 151 induzierte Spannung bzw. durch den induzierten Strom eine entsprechende Spannung bzw. ein entsprechender Strom induziert werden. Hierüber kann durch die Übertragungsspule des ersten Übertragungselements 149 ein Magnetfeld aufgebaut werden, wodurch in den Wirkbereich des Testmagnetfelds 127 durch die Übertragungsspule des ersten Übertragungselements 149 das magnetische Störsignal 131 eingebracht werden kann.

Gemäß einer weiteren Ausführungsform kann wenigstens das im Wirkbereich der Störgröße 128 angeordnete zweite Übertragungselement 151 als ein Magnetsensorelement ausgebildet sein. Über das als Magnetsensorelement ausgebildete zweite Übertragungselement 151 wird die durch das Störmotormodul 123 erzeugte Störgröße 128 detektiert. Die durch die Störgröße 128 im als Magnetsensorelement ausgebildeten zweiten Übertragungselement 151 ausgelösten elektrischen Messignale werden durch die Signalübertragungseinrichtung 143 an die Übertragungsspule des ersten Übertragungselements 149 weitergeleitet, wodurch die Übertragungsspule des ersten Übertragungselements 149 das magnetische Störsignal 131 erzeugt.

Graphik b) zeigt ein weiteres Beispiel der Bestimmung von unmittelbar benachbarten Motormodulen 125. Im gezeigten Beispiel erfolgt keine Erzeugung eines Testmagnetfelds 127. Stattdessen wird nur durch entsprechende Bestromung wenigstens einer Antriebsspule 115 des als Störmotormodul 123 ausgewählten Motormoduls 117 eine entsprechende Störgröße 128 erzeugt.

Im gezeigten Beispiel sind die zueinander beabstandeten Motormodule 117 jeweils mit Magnetsensorelementen 133 ausgebildet.

Die Signalübertragungseinrichtung 143 ist weiterhin gemäß der Ausführungsform in Grafik a) ausgebildet. Das zweite Übertragungselement 151 ist im Wirkbereich der Störgröße 128 angeordnet und ausgebildet, die Störgröße 128 zu detektieren. Das zweite Übertragungselement 151 kann weiterhin als Übertragungsspule oder als Hallsensor ausgebildet sein. Das erste Übertragungselement 149 ist in einem Wirkbereich eines Magnetfeldsensors 133 des als Testmotormodul 121 ausgewählten Motormoduls 1117 angeordnet und eingerichtet, ein magnetisches Störsignal 131 zu erzeugen und in den Wirkbereich des Magnetsensorelements 133 einzubringen. Das erste Übertragungselement 149 kann hierzu als Übertragungsspule ausgebildet sein.

Durch Übertragung des magnetischen Störsignals 131 in den Wirkbereich des Magnetsensorelements 133 durch das erste Übertragungselement 149 der Signalübertragungseinrichtung 143 kann das magnetische Störsignal 131 über das Magnetsensorelement 133 des als Testmotormodul 121 ausgewählten Motormoduls 117 detektiert werden.

Die Anwesenheit eines zum Testmotormodul 121 unmittelbar benachbarten Motormoduls 125 wird in diesem Fall nicht aufgrund einer durch die Störgröße 128 des als Störmotormodul 123 ausgewählten Motormoduls 117 im Testmagnetfeld 127 des als Testmotormodul 121 ausgewählten Motormoduls 117 erzeugten Störung ermittelt. Stattdessen wird ein zum Testmotormodul 121 unmittelbar benachbartes Motormodul 125 registriert, wenn durch wenigstens einen Magnetfeldsensor 133 des als Testmotormodul 121 ausgewählten Motormoduls 117 das durch das erste Übertragungselement 149 in den Wirkbereich des Magnetsensorelements 133 eingebrachten Störsignal 131 detektiert wird.

Die Identifikation desjenigen als Störmotormodul 123 ausgewählten Motormoduls 117, das unmittelbar zum Testmotormodul 121 benachbart angeordnet ist, erfolgt analog zu den oben beschriebenen Verfahrensschritten, indem die Erzeugung der Störgrößen 128 durch die verschiedenen als Störmotormodule 123 ausgewählten Motormodule 117 zeitlich nacheinander ausgeführt wird.

In Graphik c) sind gemäß der Ausführungsform in Figur 5 Motormodule 117 zu zwei Motormodulsträngen 135 zusammengefasst. Die Signalübertragungseinrichtung 147 ist zwischen zwei Randmotormodulen 141-1, 141-2 der nebeneinander angeordneten Motormodulstränge 135-1, 135-2 positioniert. Die Funktionsweise der Signalübertragungseinrichtung 147 ist in der gezeigten Ausführungsform analog zur Funktionsweise der Ausführungsform in Graphik a).

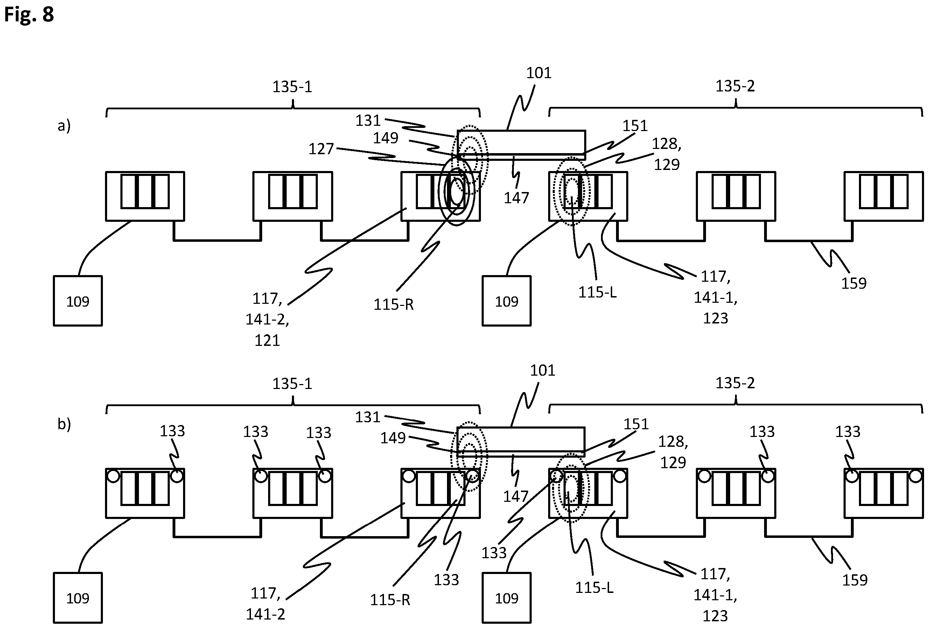

Fig. 8 zeigt eine weitere schematische Darstellung des linearen Transportsystems 100 gemäß einer weiteren Ausführungsform.

In der gezeigten Ausführungsform ist die Signalübertragungseinrichtung 147 an einer beweglichen Einheit 101 des linearen Transportsystems 100 positioniert. Indem die bewegliche Einheit 101 entlang der Führungsschiene 105 zu den gewünschten Motormodulen 117 der stationären Einheit 103 bewegt wird, können die ersten und zweiten Übertragungselemente 149, 151 der Signalübertragungseinrichtung 147 jeweils in den Wirkbereich des Testmagnetfelds 127 eines als Testmotormodul 121 ausgewählten Motormoduls 117 und in den Wirkbereich der Störgröße 128 eines als Störmotormodul 123 ausgewählten Motormoduls 117 positioniert werden.

Die Signalübertragungseinrichtung 147 kann somit durch Verfahren der beweglichen Einheit 101 zu den jeweils zu untersuchenden Motormodulen 107 verfahren werden. Die Funktionsweise der Signalübertragungseinrichtung 147 wird bei Positionierung der beweglichen Einheit 101 in einer Übertragungsposition, in der das erste Übertragungselement 149 im Wirkbereich des Testmagnetfelds 127 des Testmotormoduls 121 und das zweite Übertragungselement 151 im Wirkbereich der Störgröße 128 des Störmotormoduls 123 positioniert sind, gemäß der Ausführungsform in Figur 7 bewirkt.

Die ersten und/oder zweiten Übertragungselemente 151 können als Übertragungsspulen ausgebildet sein. Die Übertragungsspulen können beispielsweise als Leiterbahnen in Leiterplatten des Läufers 113 der beweglichen Einheit 101 ausgebildet sein. Beispielsweise können die Übertragungsspulen der ersten und zweiten Übertragungselemente 149, 151 jeweils um Antriebsmagnetelemente 119 des Läufers 113 herum angeordnet sein.

Das in Grafik b) dargestellte Beispiel stellt den analogen Fall zur Grafik b) der Fig. 7 dar. Im gezeigten Beispiel weisen die Motormodule 117 Magnetsensorelemente 133 auf. Die Das zweite Übertragungselement 151 ist im Wirkbereich der Störgröße 128 des Störmotormoduls 123 angeordnet und das erste Übertragungselement 149 ist im Wirkbereich wenigstens eines Magnetsensorelements 133 des Testmotormoduls 121 angeordnet.

Das zum Testmotormodul 121 unmittelbar benachbarte Motormodul 125 wird entsprechend dem Beispiel in Fig. 7 b) registriert, indem die Störgröße 128 des Störmotormodul 123 durch das zweite Übertragungselement 151 detektiert, durch das erste Übertragungselement 149 ein entsprechendes magnetisches Störsignal 131 in den Wirkbereich wenigstens eines Magnetsensorelements 133 des Testmotormoduls 121 eingebracht und durch das jeweilige Magnetsensorelement 133 detektiert wird.

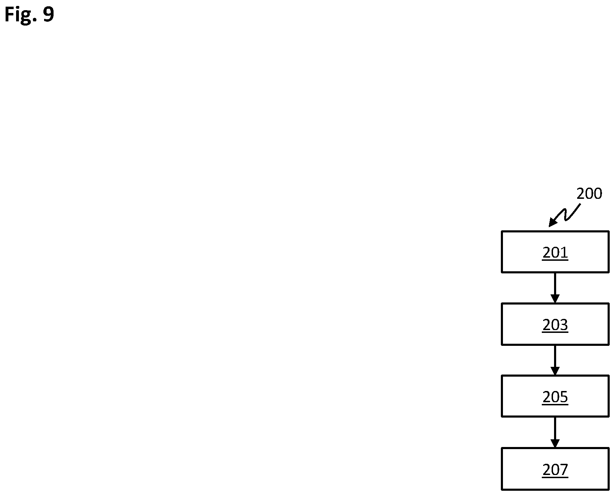

Fig. 9 zeigt ein Flussdiagramm des Verfahrens 200 zum Betreiben eines linearen Transportsystems 100 gemäß einer Ausführungsform.

Zum Betreiben eines linearen Transportsystems 100 werden in einem Testmagnetfelderzeugungsschritt 201 zunächst Steuersignale von der Steuereinheit 109 an wenigstens eine Antriebsspule 115 eines Testmotormoduls 121 zum Erzeugen eines Testmagnetfelds 127 ausgegeben.

In einem Störgrößenerzeugungsschritt 203 werden Steuersignale von der Steuereinheit 109 an wenigstens eine Antriebsspule 115 wenigstens eines Störmotormoduls 123 zum Erzeugen einer Störgröße 128 ausgegeben.

In einem Störungsermittlungsschritt 205 wird durch die Steuereinheit 109 eine durch die Störgröße 128 verursachte Störung des Testmagnetfelds 127 ermittelt.

In einem Anordnungsermittlungsschritt 207 wird durch die Steuereinheit 109 ein zum Testmotormodul 121 unmittelbar benachbartes Motormodul 125 ermittelt, falls die ermittelte Störung des Testmagnetfelds durch die ermittelte Störgröße 128 einen vordefinierten Grenzwert erreicht oder überschreitet.

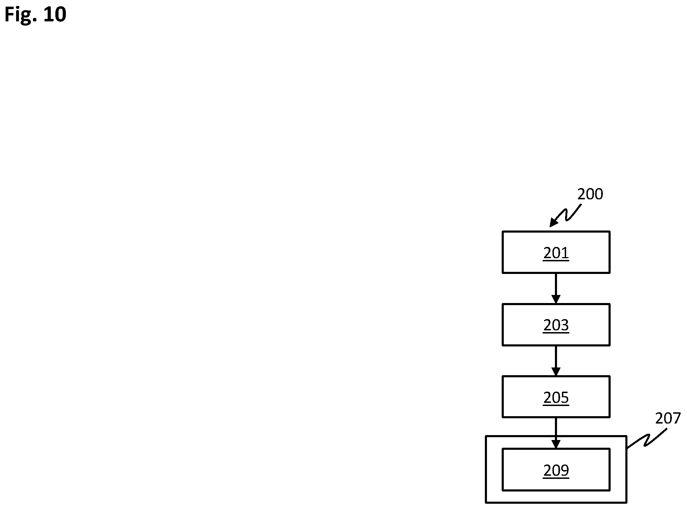

Fig. 10 zeigt ein weiteres Flussdiagramm des Verfahrens 200 zum Betreiben eines linearen Transportsystems 100 gemäß einer weiteren Ausführungsform.

Die Ausführungsform der Figur 10 basiert auf der Ausführungsform der Figur 9 und umfasst alle dort beschriebenen Verfahrensschritte.

In der gezeigten Ausführungsform umfasst der Anordnungsermittlungsschritt 207 einen Identifizierungsschritt 209. Im Identifizierungsschritt 209 wird das wenigstens eine Störmotormodul 123 als das zum Testmotormodul 121 unmittelbar benachbarte Motormodul 125 identifiziert. Die Identifizierung erfolgt basierend auf einer zeitlichen Abfolge der Erzeugung der Störgröße 128 und der Ermittlung der Störung des Testmagnetfelds 127.

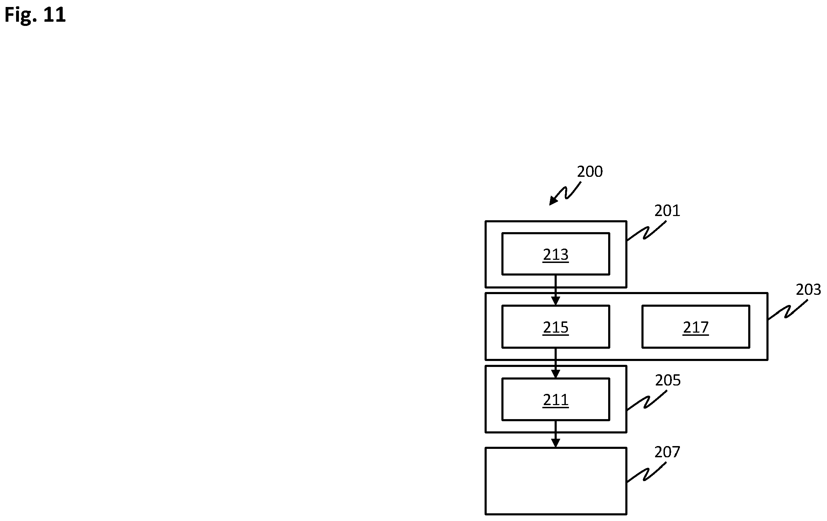

Fig. 11 zeigt ein weiteres Flussdiagramm des Verfahrens 200 zum Betreiben eines linearen Transportsystems 100 gemäß einer weiteren Ausführungsform.

Die Ausführungsform der Figur 11 basiert auf der Ausführungsform in Figur 9 und umfasst alle dort beschriebenen Verfahrensschritte.

In der gezeigten Ausführungsform umfasst der Testfeldmagnetfelderzeugungsschritt 201 das Ausgeben von Steuersignalen durch die Steuereinheit 109 an die Antriebsspule 115 des Testmotormoduls 121 zum Bestromen der Antriebsspule 115 des Testmotormoduls 121 mit einem ersten Betriebsstrom I1 in einem ersten Bestromungsschritt 213.

Der Störgrößenerzeugungsschritt 203 umfasst das Ausgeben von Steuersignalen durch die Steuereinheit 109 an die Antriebsspule 115 des wenigstens einen Störmotormoduls 123 zum Bestromen der Antriebsspule 115 des Störmotormoduls 123 mit einem zweiten Betriebsstrom I2 in einem zweiten Bestromungsschritt 215.

Alternativ werden von der Steuereinheit 109 Steuersignale an die Antriebsspule 115 ausgegeben und die Antriebsspule 115 des Störmotormoduls 123 wird in einem Schaltschritt 217 in einen Kurzschlusszustand geschaltet. Hierbei ist die Störgröße 128 durch den Kurzschlusszustand gegeben, in den die Antriebsspule 115 des als Störmotormodul 123 ausgewählten Motormoduls 117 durch die Steuersignale geschaltet ist. In der kurzgeschlossenen Antriebsspule 115 wird durch Wechselwirkung des Testmagnetfelds 127 eine induzierte Spannung bzw. ein induzierter Strom erzeugt, auf der/dem basierend durch die Antriebsspule 115 ein entsprechendes Störmagnetfeld 129 erzeugt wird.

Die Ermittlung der Störung des Testmagnetfelds 127 im Störungsermittlungsschritt 205 erfolgt in der gezeigten Ausführungsform durch die Ermittlung einer Spannungsänderung einer Betriebsspannung U der das Testmagnetfeld 127 erzeugenden Antriebsspule 115 des Testmotormoduls 121 durch die Steuereinheit 109 in einem Spannungsänderungsermittlungsschritt 211. Der vordefinierte Grenzwert zur Ermittlung der Störung des Testmagnetfelds 127 wird hierbei durch eine minimale Spannungsänderung definiert.

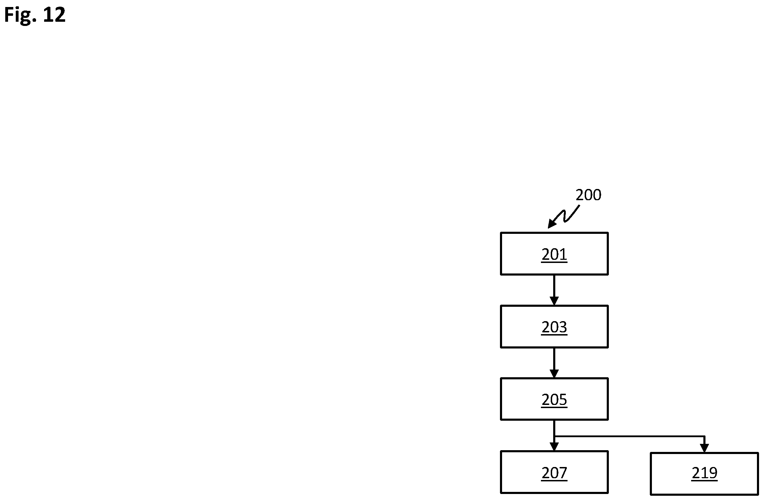

Fig. 12 zeigt ein weiteres Flussdiagramm des Verfahrens 200 zum Betreiben eines linearen Transportsystems 100 gemäß einer weiteren Ausführungsform.

Die Ausführungsform in Figur 12 basiert auf der Ausführungsform in Figur 9 und umfasst alle dort beschriebenen Verfahrensschritte.

In der gezeigten Ausführungsform wird in einem weiteren Anordnungsermittlungsschritt 219 ermittelt, dass zum Testmotormodul 121 kein unmittelbar benachbartes Motormodul 125 existiert, falls für keine der erzeugten Störgrößen 128 der als Störmotormodule 123 ausgewählten Motormodule 117 eine Störung des Testmagnetfeld 127 ermittelt wird.

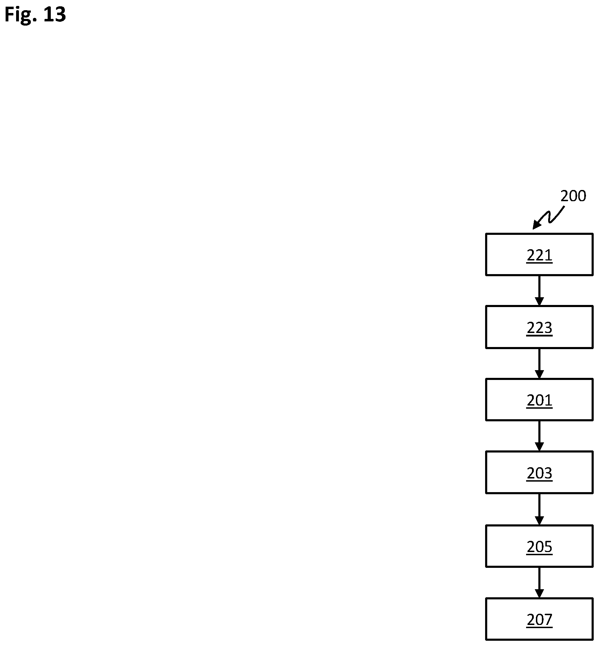

Fig. 13 zeigt ein weiteres Flussdiagramm des Verfahrens 200 zum Betreiben eines linearen Transportsystems 100 gemäß einer weiteren Ausführungsform.

Die Ausführungsform in Figur 13 basiert auf der Ausführungsform in Figur 9 und umfasst alle dort beschriebenen Verfahrensschritte.

In der gezeigten Ausführungsform ist der Fall beschrieben, dass die Motormodule 117 in entsprechenden Motormodulsträngen 135 zusammengefasst sind.

In einem Motormodulbestimmungsschritt 221 wird ein Testrandmotormodul 137 eines Testmotormodulstrangs 139 und ein Störrandmotormodul 143 eines Störmotormodulstrangs 145 durch die Steuereinheit 109 bestimmt.

In einem Motormodulauswahlschritt 223 wird das Testrandmotormodul 137 des Testmotormodulstrangs 139 als Testmotormodul 121 zum Erzeugen des Testmagnetfelds 127 und das Störrandmotormodul 143 des Störmotormodulstrangs 145 als Störmotormodul 123 zum Erzeugen der Störgröße 128ausgewählt.

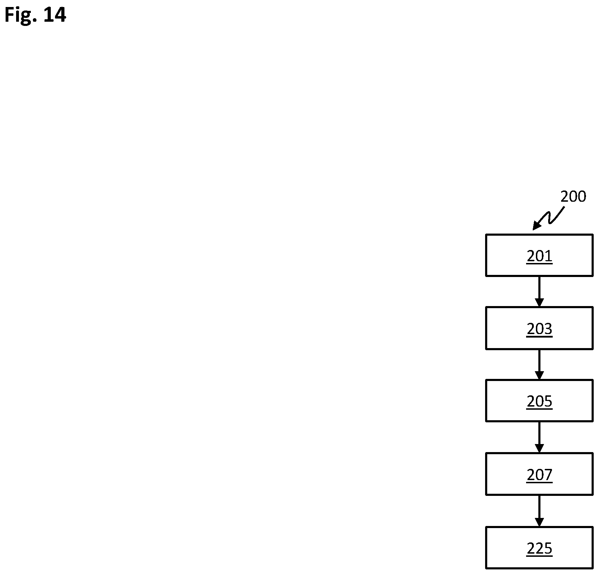

Fig. 14 zeigt ein weiteres Flussdiagramm des Verfahrens 200 zum Betreiben eines linearen Transportsystems 100 gemäß einer weiteren Ausführungsform.

Die Ausführungsform in Figur 14 basiert auf der Ausführungsform in Figur 9 und umfasst alle dort beschriebenen Verfahrensschritte.

In der gezeigten Ausführungsform wird in einem Topologieermittlungsschritt 225 durch die Steuereinheit 109 eine Topologie der Motormodule 117 der stationären Einheit 103 durch Ermitteln von wenigstens einem unmittelbar benachbarten Motormodul 125 für die Motormodule 117 der Mehrzahl der Motormodule 117 der stationären Einheit 103 ermittelt.

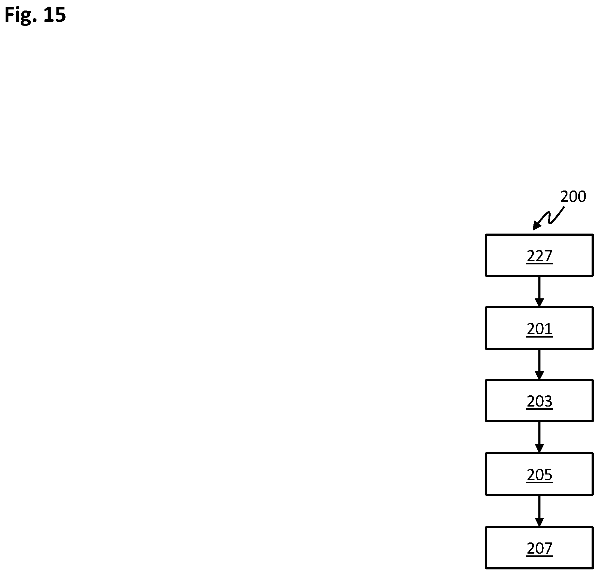

Fig. 15 zeigt ein weiteres Flussdiagramm des Verfahrens 200 zum Betreiben eines linearen Transportsystems 100 gemäß einer weiteren Ausführungsform.

Die Ausführungsform der Figur 15 basiert auf der Ausführungsform der Figur 9 und umfasst alle dort beschriebenen Verfahrensschritte.

In der gezeigten Ausführungsform umfasst das lineare Transportsystem 100 die an wenigstens einer beweglichen Einheit 101 ausgebildete Signalübertragungseinrichtung 147. In einem Positionierungsschritt 227 werden von der Steuereinheit 109 Steuersignale an Antriebsspulen 115 der Motormodule 117 zum Positionieren der beweglichen Einheit 101 in einer Übertragungsposition ausgegeben. In der Übertragungsposition der beweglichen Einheit 101 sind die ersten und zweiten Übertragungselemente 149, 151 der Signalübertragungseinrichtung 147 in einem Wirkbereich des Testmagnetfelds 127 des Testmotormoduls 121 und dem Wirkbereich der Störgröße 128 des Störmotormoduls 123 positioniert. Über die ersten und zweiten Übertragungselemente 149, 151 kann somit durch die Signalübertragungseinrichtung 147 ein durch die Störgröße 128 erzeugtes magnetisches Störsignal in den Wirkbereich des Testmagnetfelds 127 gebracht werden.

Die Ausführungsformen des Verfahrens 200 der Figuren 9 bis 15 können beliebig kombiniert werden.

### Bezugszeichenliste

- 100: lineares Transportsystem
- 101: bewegliche Einheit
- 103: stationäre Einheit
- 105: Führungsschiene
- 107: Linearmotor
- 109: Steuereinheit
- 111: Stator
- 113: Läufer
- 114: Statorzahn
- 115: Antriebsspule
- 115-L: erste Randantriebsspule
- 115-R: zweite Randantriebsspule
- 117: Motormodul
- 117-1: erstes Motormodul
- 117-2: zweites Motormodul
- 117-3: drittes Motormodul
- 117-4: viertes Motormodul
- 117-5: fünftes Motormodul
- 117-6: sechstes Motormodul
- 117-7: siebtes Motormodul
- 117-8: achtes Motormodul
- 119: Antriebsmagnetelement
- 121: Testmotormodul
- 123: Störmotormodul
- 125: unmittelbar benachbartes Motormodul
- 127: Testmagnetfeld
- 128: Störgröße
- 129: Störmagnetfeld
- 131: magnetisches Störsignal
- 132: Kurzschluss
- 133: Magnetsensorelement
- 135: Motormodulstrang
- 135-1: erster Motormodulstrang
- 135-2: zweiter Motormodulstrang
- 135-3: dritter Motormodulstrang
- 135-4: vierter Motormodulstrang
- 137: Testrandmotormodul
- 139: Testmotormodulstrang
- 141-1: erstes Randmotormodul
- 141-2: zweites Randmotormodul
- 143: Störrandmotormodul
- 145: Störmotormodulstrang
- 147: Signalübertragungseinrichtung
- 149: erstes Übertragungselement
- 151: zweites Übertragungselement
- 153: Verbindungsleitung
- 155: Spalt
- 159: Datenleitung
- 161: erstes Ende
- 163: zweites Ende
- 165: Reglereinheit
- 167: Weichenmodul

- 200: Verfahren
- 201: Testmagnetfelderzeugungsschritt
- 203: Störgrößenerzeugungsschritt
- 205: Störungsermittlungsschritt
- 207: Anordnungsermittlungsschritt
- 209: Identifizierungsschritt
- 211: Spannungsänderungsermittlungsschritt
- 213: erster Bestromungsschritt
- 215: zweiter Bestromungsschritt
- 217: Schaltschritt
- 219: weiterer Anordnungsermittlungsschritt
- 221: Motormodulbestimmungsschritt
- 223: Motormodulauswahlschritt
- 225: Topologieermittlungsschritt
- 227: Positionierungsschritt

- U: Betriebsspannung
- A: Spannungsamplitude
- φ: Spannungsphase
- I1: erster Betriebsstrom
- I2: zweiter Betriebsstrom
- t: Zeit

## Patentansprüche

1. Computer implementiertes Verfahren zum Betreiben eines lineares Transportsystems (100) mit einer Steuereinheit (109) und einer stationären Einheit (103) mit einer Führungsschiene (105) zum Führen einer beweglichen Einheit (101) und einer Mehrzahl von entlang der Führungsschiene (105) angeordneten Motormodulen (117), wobei die Motormodule (117) jeweils Antriebsspulen (115) zum Bereitstellen eines Antriebsmagnetfelds zum Antreiben der beweglichen Einheit (101) entlang der Führungsschiene (105) umfassen, und wobei das Verfahren **gekennzeichnet ist durch**:
Ausgeben von Steuersignalen von der Steuereinheit (109) an wenigstens eine Antriebsspule (115) wenigstens eines als Testmotormodul (121) ausgewählten Motormoduls (117) der Mehrzahl von Motormodulen (117) zum Erzeugen eines Testmagnetfelds (127) des Testmotormoduls (121) in einem Testmagnetfelderzeugungsschritt (201);
Ausgeben von Steuersignalen **durch** die Steuereinheit (109) an wenigstens eine Antriebsspule (115) wenigstens eines als Störmotormodul (123) ausgewählten Motormoduls (117) der Mehrzahl von Motormodulen (117) zum Erzeugen einer Störgröße (128) des wenigstens einen Störmotormoduls (123) in einem Störgrößenerzeugungsschritt (203);
Ermitteln einer **durch** die Störgröße (128) des als Störmotormodul (123) ausgewählten Motormoduls (117) verursachten Störung des Testmagnetfelds (127) des als Testmotormodul (121) ausgewählten Motormoduls 117) **durch** die Steuereinheit (109) in einem Störungsermittlungsschritt (205); und
Ermitteln eines zum als Testmotormodul (121) ausgewählten unmittelbar benachbarten Störmotormoduls (123) **durch** die Steuereinheit (109) in einem Anordnungsermittlungsschritt (207), falls die ermittelte Störung des Testmagnetfelds (127) durch die Störgröße (128) einen vordefinierten Grenzwert erreicht oder überschreitet.

2. Verfahren (200) nach Anspruch 1, wobei der Anordnungsermittlungsschritt (207) umfasst:
Identifizieren des wenigstens einen Störmotormoduls (123) als das zum Testmotormodul (121) unmittelbar benachbarte Motormodul (125) basierend auf einer zeitlichen Abfolge der Erzeugung der Störgröße (128) durch das wenigstens eine Störmotormodul (123) und der Ermittlung der Störung des Testmagnetfelds (127) durch die Steuereinheit (109) in einem Identifizierungsschritt (209).

3. Verfahren (200) nach Anspruch 1 oder 2, wobei der Störungsermittlungsschritt (205) umfasst:
Ermitteln einer Spannungsänderung einer Betriebsspannung (U) der das Testmagnetfeld (127) erzeugenden Antriebsspule (115) des Testmotormoduls (121) durch die Steuereinheit (109) in einem Spannungsänderungsermittlungsschritt (211), wobei der vordefinierte Grenzwert durch die Spannungsänderung definiert ist.

4. Verfahren (200) nach Anspruch 3, wobei die Spannungsänderung eine Änderung einer Spannungsamplitude (A) und/oder eine Änderung einer Spannungsphase (φ) der Betriebsspannung (U) umfasst.

5. Verfahren (200) nach einem der voranstehenden Ansprüche, wobei der Testmagnetfelderzeugungsschritt (201) umfasst:
Ausgeben von Steuersignalen durch die Steuereinheit (109) an die Antriebsspule (115) des Testmotormoduls (121) zum Bestromen der Antriebsspule (115) des Testmotormoduls (121) mit einem ersten Betriebsstrom (I1) in einem ersten Bestromungsschritt (213).

6. Verfahren (200) nach einem der voranstehenden Ansprüche, wobei der Störgrößenerzeugungsschritt (203) umfasst:
Ausgeben von Steuersignalen durch die Steuereinheit (109) an die Antriebsspule (115) des wenigstens einen Störmotormoduls (123) zum Bestromen der Antriebsspule (115) des wenigstens einen Störmotormoduls (123) mit einem zweiten Betriebsstrom (I2) und zum Erzeugen eines Störmagnetfelds (129) in einem zweiten Bestromungsschritt (215), wobei die Störgröße (128) durch das Störmagnetfeld (129) gegeben ist.

7. Verfahren (200) nach einem der voranstehenden Ansprüche, wobei der Störgrößenerzeugungsschritt (203) umfasst:
Ausgeben von Steuersignalen durch die Steuereinheit (109) an die Antriebsspule (115) des wenigstens einen Störmotormoduls (123) zum Erzeugen der Störgröße (128) durch Schalten der Antriebsspule (115) des wenigstens einen Störmotormoduls (123) in einen Kurzschlusszustand in einem Schaltschritt (217), wobei die Störgröße (128) durch einen Kurzschluss (132) in der Antriebsspule (115) des als Störmotormodul (123) ausgewählten Motormoduls (117) gegeben ist.

8. Verfahren (200) nach einem der voranstehenden Ansprüche 5 bis 7, wobei der erste Betriebsstrom (I1) der Antriebsspule (115) des Testmotormoduls (121) einen Verlauf aus der folgenden Liste aufweist: Sinusförmiger Verlauf, Cosinusförmiger Verlauf, Sägezahnförmiger Verlauf, Dreieckförmiger Verlauf, Rechteckförmiger Verlauf.

9. Verfahren (200) nach einem der voranstehenden Ansprüche 6 bis 8, wobei der zweite Betriebsstrom (I2) der Antriebsspule (115) des wenigstens einen Störmotormoduls (123) einen Verlauf aus der folgenden Liste aufweist: Sinusförmiger Verlauf, Cosinusförmiger Verlauf, Sägezahnförmiger Verlauf, Dreieckförmiger Verlauf, Rechteckförmiger Verlauf oder ein Nullstrom ist.

10. Verfahren (200) nach einem der voranstehenden Ansprüche, wobei für eine Mehrzahl von als Störmotormodule (123) ausgewählten Motormodulen (117) durch Ansteuern der jeweiligen Antriebsspulen (115) der als Störmotormodule (123) ausgewählten Motormodule (117) eine Mehrzahl von Störgrößen (128) erzeugt werden, und wobei für die Mehrzahl von Störgrößen (128) überprüft wird, ob Störungen des Testmagnetfelds (127) des Testmotormoduls (121) ermittelt werden, und/oder wobei das Erzeugen der Mehrzahl von Störgrößen (128) der Mehrzahl von Störmotormodulen (123) zeitlich nacheinander durchgeführt wird.

11. Verfahren (200) nach einem der voranstehenden Ansprüche, wobei für eine Mehrzahl von als Testmotormodule (121) ausgewählten Motormodulen (117) durch Ansteuern der jeweiligen Antriebsspulen (115) der als Testmotormodule (121) ausgewählten Motormodule (117) eine Mehrzahl von Testmagnetfeldern (127) erzeugt werden.

12. Verfahren (200) nach Anspruch 10 und 11, wobei das Erzeugen der Mehrzahl von Testmagnetfeldern (127) der Mehrzahl von als Testmotormodule (121) ausgewählten Motormodule (117) zeitgleich und das Erzeugen der Mehrzahl von Störgrößen (128) der Mehrzahl von als Störmotormodule (123) ausgewählten Motormodule (117) zeitlich nacheinander durchgeführt wird, oder wobei das Erzeugen der Mehrzahl von Testmagnetfeldern (127) der Mehrzahl von als Testmotormodule (121) ausgewählten Motormodule (117) zeitlich nacheinander und das Erzeugen der Mehrzahl von Störgrößen (128) der Mehrzahl von als Störmotormodule (123) ausgewählten Motormodule (117) zeitgleich durchgeführt wird, und/oder wobei das Verfahren (100) ferner umfasst:
Ermitteln, dass zum Testmotormodul (121) kein unmittelbar benachbartes Motormodul (125) existiert, falls für keine der erzeugten Störgrößen (128) der als Störmotormodule (123) ausgewählten Motormodule (117) eine Störung des Testmagnetfelds (127) ermittelt wird, in einem weiteren Anordnungsermittlungsschritt (219).

13. Verfahren (200) nach einem der voranstehenden Ansprüche, wobei die Motormodule (117) der Mehrzahl von Motormodulen (117) der stationären Einheit (103) zu Motormodulsträngen (135) zusammengefasst sind, wobei jeder Motormodulstrang (135) wenigstens zwei miteinander leitungsgebunden verbundene Motormodule (117) aufweist, und wobei das Verfahren (200) umfasst:
Bestimmen eines Testrandmotormoduls (137) eines Testmotormodulstrangs (139) und eines Störrandmotormoduls (143) eines Störmotormodulstrangs (145) durch die Steuereinheit (109) in einem Motormodulbestimmungsschritt (221), wobei das Testrandmotormodul (137) mit nur einem weiteren Motormodul (117) des Testmotormodulstrangs (139) leitungsgebunden verbunden ist, und wobei das Störrandmotormodul (143) mit nur einem weiteren Motormodul (117) des Störmotormodulstrangs (145) leitungsgebunden verbunden ist; und
Auswählen des Testrandmotormoduls (137) des Testmotormodulstrangs (139) als Testmotormodul (121) zum Erzeugen des Testmagnetfelds (127) und Auswählen des Störrandmotormoduls (143) des Störmotormodulstrangs (145) als Störmotormodul (123) zum Erzeugen der Störgröße (128) durch die Steuereinheit (109) in einem Motormodulauswahlschritt (223).

14. Verfahren (200) nach einem der voranstehenden Ansprüche, wobei das Verfahren (200) ferner umfasst:
Ermitteln einer Topologie der Motormodule (117) der stationären Einheit (103) durch Ermitteln von wenigstens einem unmittelbar benachbarten Motormodul (125) für die Motormodule (117) der Mehrzahl von Motormodulen (117) der stationären Einheit (103) durch die Steuereinheit (109) in einem Topologieermittlungsschritt (225), und/oder wobei das Verfahren bei einem Aufstarten des linearen Transportsystems (100) und/oder nach einem Hinzufügen und/oder Entfernen eines Motormoduls (117) zu/von der Mehrzahl von Motormodulen (117) durchgeführt wird.

15. Lineares Transportsystem (100) mit einer Steuereinheit (109) und einer stationären Einheit (103), wobei die stationäre Einheit eine Führungsschiene (105) zum Führen einer beweglichen Einheit (101) und eine Mehrzahl von entlang der Führungsschiene angeordneten Motormodulen (117) umfasst, wobei die Motormodule (117) jeweils Antriebsspulen (115) zum Bereitstellen eines Antriebsmagnetfelds zum Antreiben der beweglichen Einheit (101) entlang der Führungsschiene umfassen, wobei die Antriebsspulen (115) eingerichtet sind, ein Testmagnetfeld (127) und/oder eine Störgröße (128) zu generieren, **dadurch gekennzeichnet, dass** die Steuereinheit (109) eingerichtet ist, das Verfahren zum Betreiben eines linearen Transportsystems (100) nach einem der voranstehenden Ansprüche 1 bis 14 auszuführen.

## Claims

1. A computer-implemented method for operating a linear transport system (100) having a controller (109) and a stationary unit (103) having a guide rail (105) for guiding a movable unit (101) and a plurality of motor modules (117) arranged along the guide rail (105), wherein the motor modules (117) each comprise drive coils (115) for providing a drive magnetic field for driving the movable unit (101) along the guide rail (105), and wherein the method is **characterized by**:
outputting control signals from the controller (109) to at least one drive coil (115) of at least one motor module (117) selected as a test motor module (121) from the plurality of motor modules (117) to generate a test magnetic field (127) of the test motor module (121) in a test magnetic field generating step (201);
outputting control signals by the controller (109) to at least one drive coil (115) of at least one motor module (117) selected as an interference motor module (123) from the plurality of motor modules (117) for generating an interference variable (128) of the at least one interference motor module (123) in an interference variable generating step (203);
determining an interference of the test magnetic field (127) of the motor module (117) selected as the test motor module (121) caused by the interference variable (128) of the motor module (117) selected as the interference motor module (123) by the controller (109) in an interference determining step (205); and
determining an immediately adjacent interference motor module (123) selected as the test motor module (121) by the controller (109) in an arrangement determining step (207) if the detected interference of the test magnetic field (127) by the interference variable (128) reaches or exceeds a predefined limit value.

2. The method (200) according to claim 1, wherein the arrangement determining step (207) comprises:
identifying the at least one interference motor module (123) as the motor module (125) immediately adjacent to the test motor module (121) based on a temporal sequence of the generation of the interference variable (128) by the at least one interference motor module (123) and the determination of the interference of the test magnetic field (127) with the aid of the controller (109) in an identifying step (209).

3. The method (200) according to claim 1 or 2, wherein the interference determining step (205) comprises:
determining a voltage change of an operating voltage (U) of the drive coil (115) of the test motor module (121) generating the test magnetic field (127) with the aid of the controller (109) in a voltage change determining step (211), wherein the predefined limit value is defined by the voltage change.

4. The method (200) according to claim 3, wherein the voltage change comprises a change in a voltage amplitude (A) and/or a change in a voltage phase (φ) of the operating voltage (U).

5. The method (200) according to any of the preceding claims, wherein the test magnetic field generating step (201) comprises:
outputting control signals with the aid of the controller (109) to the drive coil (115) of the test motor module (121) for energizing the drive coil (115) of the test motor module (121) with a first operating current (I1) in a first energizing step (213).

6. The method (200) according to any one of the preceding claims, wherein the interference generating step (203) comprises:
outputting control signals by the controller (109) to the drive coil (115) of the at least one interference motor module (123) for energizing the drive coil (115) of the at least one interference motor module (123) with a second operating current (I2) and for generating an interference magnetic field (129) in a second energizing step (215), wherein the interference variable (128) is given by the interference magnetic field (129).

7. The method (200) according to any one of the preceding claims, wherein the interference variable generating step (203) comprises:
outputting control signals by the controller (109) to the drive coil (115) of the at least one interference motor module (123) for generating the interference variable (128) by switching the drive coil (115) of the at least one interference motor module (123) into a short-circuit state in a switching step (217), wherein the interference variable (128) is provided by a short circuit (132) in the drive coil (115) of the motor module (117) selected as the interference motor module (123).

8. The method (200) according to any one of the preceding claims 5 to 7, wherein the first operating current (I1) of the drive coil (115) of the test motor module (121) comprises a waveform from the following list: sinusoidal waveform, cosine waveform, sawtooth waveform, triangular waveform, square waveform.

9. The method (200) according to any one of the preceding claims 6 to 8, wherein the second operating current (I2) of the drive coil (115) of the at least one interference motor module (123) comprises a waveform from the following list: sinusoidal waveform, cosine waveform, sawtooth waveform, triangular waveform, square waveform, or zero current.

10. The method (200) according to any one of the preceding claims, wherein for a plurality of motor modules (117) selected as interference motor modules (123), a plurality of interference variables (128) are generated by actuating the respective drive coils (115) of the motor modules (117) selected as interference motor modules (123), and wherein the plurality of interference variables (128) are checked to determine whether interferences of the test magnetic field (127) of the test motor module (121) are detected and/or wherein the generation of the plurality of interference variables (128) of the plurality of interference motor modules (123) is carried out sequentially in time.

11. The method (200) according to any one of the preceding claims, wherein for a plurality of motor modules (117) selected as test motor modules (121), a plurality of test magnetic fields (127) is generated by actuating the respective drive coils (115) of the motor modules (117) selected as test motor modules (121).

12. The method (200) according to claims 10 and 12, wherein generating the plurality of test magnetic fields (127) of the plurality of motor modules (117) selected as test motor modules (121) is carried out simultaneously and generating the plurality of interference variables (128) of the plurality of motor modules (117) selected as interference motor modules (123) is carried out sequentially over time , or wherein generating the plurality of test magnetic fields (127) of the plurality of motor modules (117) selected as test motor modules (121) is carried out sequentially in time and generating the plurality of interference variables (128) of the plurality of motor modules (117) selected as interference motor modules (123) is carried out simultaneously, and/or wherein the method (100) further includes: determining that there is no immediately adjacent motor module (125) to the test motor module (121) if no interference of the test magnetic field (127) is determined for any of the generated interference variables (128) of the motor modules selected as interference motor modules (123) in a further arrangement determining step (219).

13. The method (200) according to any one of the preceding claims, wherein the motor modules (117) of the plurality of motor modules (117) of the stationary unit (103) are combined into motor module strings (135), wherein each motor module string (135) comprises at least two motor modules (117) connected to each other by wires (117) connected to each other in a wired manner, and wherein the method (200) comprises:
determining a test edge motor module (137) of a test motor module string (139) and an interference edge motor module (143) of an interference motor module string (145) with the aid of the controller (109) in a motor module determining step (221), wherein the test edge motor module (137) is wire-connected to only one further motor module (117) of the test motor module string (139), and wherein the interference edge motor module (143) is wire-connected to only one other motor module (117) of the interference motor module string (145); and
selecting the test edge motor module (137) of the test motor module string (139) as the test motor module (121) for generating the test magnetic field (127) and selecting the interference edge motor module (143) of the interference motor module string (145) as the interference motor module (123) (123) for generating the interference variable (128) with the aid of the controller (109) in a motor module selecting step (223).

14. The method (200) according to any one of the preceding claims, wherein the method (200) further comprises:
determining a topology of the motor modules (117) of the stationary unit (103) by determining at least one immediately adjacent motor module (125) for the motor modules (117) of the plurality of motor modules (117) of the stationary unit (103) with the aid of the controller (109) in a topology determining step (225), and/or wherein the method is carried out when starting up the linear transport system (100) and/or after adding and/or removing a motor module (117) to/from the plurality of motor modules (117).

15. A linear transport system (100) having a controller (109) and a stationary unit (103), wherein the stationary unit comprises a guide rail (105) for guiding a movable unit (101) and a plurality of motor modules (117) arranged along the guide rail, wherein the motor modules (117) each comprise drive coils (115) for providing a drive magnetic field for driving the movable unit (101) along the guide rail, wherein the drive coils (115) are arranged to generate a test magnetic field (127) and/or an interference variable (128), **characterized in that** the controller (109) is arranged to carry out the method for operating a linear transport system (100) according to any one of the preceding claims 1 to 14.

## Revendications

1. Procédé mis en œuvre par ordinateur pour faire fonctionner un système de transport linéaire (100) comportant une unité de commande (109) et une unité stationnaire (103) dotée d'un rail de guidage (105) pour guider une unité mobile (101) et une pluralité de modules de moteur (117) disposés le long du rail de guidage (105), les modules de moteur (117) comprenant respectivement des bobines d'entraînement (115) pour fournir un champ magnétique d'entraînement destiné à entraîner l'unité mobile (101) le long du rail de guidage (105), et le procédé étant **caractérisé par** :
l'envoi, par l'unité de commande (109), lors d'une étape de génération de champ magnétique de test (201), de signaux de commande à au moins une bobine d'entraînement (115) d'au moins un module de moteur (117), sélectionné comme module de moteur de test (121) de la pluralité de modules de moteur (117), afin de générer un champ magnétique de test (127) du module de moteur de test (121) ;
l'envoi, par l'unité de commande (109), lors d'une étape de génération de grandeur perturbatrice (203), de signaux de commande à au moins une bobine d'entraînement (115) d'au moins un module de moteur (117) de la pluralité de modules de moteur (117), sélectionné comme module de moteur perturbateur (123), afin de générer une grandeur perturbatrice (128) dudit au moins un module de moteur perturbateur (123) ;
la détermination, par l'unité de commande (109), lors d'une étape de détermination de perturbation (205), d'une perturbation du champ magnétique de test (127) du module de moteur (117) sélectionné comme module de moteur de test (121), provoquée par la grandeur perturbatrice (128) du module de moteur (117) sélectionné comme module de moteur perturbateur (123) ; et
la détermination, par l'unité de commande (109), lors d'une étape de détermination d'agencement (207), d'un module de moteur perturbateur (123) directement adjacent au module de moteur sélectionné comme module de moteur de test (121), dans le cas où la perturbation déterminée du champ magnétique de test (127) provoquée par la grandeur perturbatrice (128) atteint ou dépasse une valeur limite prédéfinie.

2. Procédé (200) selon la revendication 1, dans lequel l'étape de détermination d'agencement (207) comprend : l'identification, par l'unité de commande (109), lors d'une étape d'identification (209), dudit au moins un module de moteur perturbateur (123) comme étant le module de moteur (125) directement adjacent au module de moteur de test (121) sur la base d'une séquence chronologique de la génération de la grandeur perturbatrice (128) par ledit au moins un module de moteur perturbateur (123) et de la détermination de la perturbation du champ magnétique de test (127).

3. Procédé (200) selon la revendication 1 ou 2, dans lequel l'étape de détermination de perturbation (205) comprend :
la détermination, par l'unité de commande (109), lors d'une étape de détermination de variation de tension (211), d'une variation de tension d'une tension de fonctionnement (U) de la bobine d'entraînement (115) du module de moteur de test (121) qui génère le champ magnétique de test (127), la valeur limite prédéfinie étant définie par la variation de tension.

4. Procédé (200) selon la revendication 3, dans lequel la variation de tension comprend une variation d'une amplitude de tension (A) et/ou une variation d'une phase de tension (φ) de la tension de fonctionnement (U).

5. Procédé (200) selon l'une des revendications précédentes, dans lequel l'étape de génération de champ magnétique de test (201) comprend :
l'envoi, par l'unité de commande (109), lors d'une première étape d'alimentation (213), de signaux de commande à la bobine d'entraînement (115) du module de moteur de test (121) afin d'alimenter la bobine d'entraînement (115) du module de moteur de test (121) avec un premier courant de fonctionnement (I1).

6. Procédé (200) selon l'une des revendications précédentes, dans lequel l'étape de génération de grandeur perturbatrice (203) comprend :
l'envoi, par l'unité de commande (109), lors d'une seconde étape d'alimentation (215), de signaux de commande à la bobine d'entraînement (115) dudit au moins un module de moteur perturbateur (123) afin d'alimenter la bobine d'entraînement (115) dudit au moins un module de moteur perturbateur (123) avec un second courant de fonctionnement (I2) et de générer un champ magnétique perturbateur (129), la grandeur perturbatrice (128) étant donnée par le champ magnétique perturbateur (129).

7. Procédé (200) selon l'une des revendications précédentes, dans lequel l'étape de génération de grandeur perturbatrice (203) comprend :
l'envoi, par l'unité de commande (109), lors d'une étape de commutation (217), de signaux de commande à la bobine d'entraînement (115) dudit au moins un module de moteur perturbateur (123) afin de générer la grandeur perturbatrice (128) par commutation de la bobine d'entraînement (115) dudit au moins un module de moteur perturbateur (123) dans un état de court-circuit, la grandeur perturbatrice (128) étant donnée par un court-circuit (132) dans la bobine d'entraînement (115) du module de moteur (117) sélectionné comme module de moteur perturbateur (123).

8. Procédé (200) selon l'une des revendications 5 à 7 précédentes, dans lequel le premier courant de fonctionnement (I1) de la bobine d'entraînement (115) du module de moteur de test (121) présente un profil choisi dans la liste suivante : profil sinusoïdal, profil cosinusoïdal, profil en dents de scie, profil triangulaire, profil rectangulaire.

9. Procédé (200) selon l'une des revendications 6 à 8 précédentes, dans lequel le second courant de fonctionnement (I2) de la bobine d'entraînement (115) dudit au moins un module de moteur perturbateur (123) présente un profil choisi dans la liste suivante : profil sinusoïdal, profil cosinusoïdal, profil en dents de scie, profil triangulaire, profil rectangulaire, ou est un courant nul.

10. Procédé (200) selon l'une des revendications précédentes, dans lequel, pour une pluralité de modules de moteur (117) sélectionnés comme modules de moteur perturbateurs (123), une pluralité de grandeurs perturbatrices (128) sont générées par commande des bobines d'entraînement respectives (115) des modules de moteur (117) sélectionnés comme modules de moteur perturbateurs (123), et dans lequel il est vérifié, pour la pluralité de grandeurs perturbatrices (128), si des perturbations du champ magnétique de test (127) du module de moteur de test (121) sont déterminées, et/ou dans lequel la génération de la pluralité de grandeurs perturbatrices (128) de la pluralité de modules de moteur perturbateurs (123) est effectuée successivement dans le temps.

11. Procédé (200) selon l'une des revendications précédentes, dans lequel, pour une pluralité de modules de moteur (117) sélectionnés comme modules de moteur de test (121), une pluralité de champs magnétiques de test (127) sont générés par commande des bobines d'entraînement respectives (115) des modules de moteur (117) sélectionnés comme modules de moteur de test (121).

12. Procédé (200) selon les revendications 10 et 11, dans lequel la génération de la pluralité de champs magnétiques de test (127) de la pluralité de modules de moteur (117) sélectionnés comme modules de moteur de test (121) est effectuée simultanément et la génération de la pluralité de grandeurs perturbatrices (128) de la pluralité de modules de moteur (117) sélectionnés comme modules de moteur perturbateurs (123) est effectuée successivement dans le temps, ou dans lequel la génération de la pluralité de champs magnétiques de test (127) de la pluralité de modules de moteur (117) sélectionnés comme modules de moteur de test (121) est effectuée successivement dans le temps et la génération de la pluralité de grandeurs perturbatrices (128) de la pluralité de modules de moteur (117) sélectionnés comme modules de moteur perturbateurs (123) est effectuée simultanément, et/ou dans lequel le procédé (100) comprend en outre :
la détermination, lors d'une autre étape de détermination d'agencement (219), du fait qu'il n'existe pas de module de moteur (125) directement adjacent au module de moteur de test (121), dans le cas où aucune perturbation du champ magnétique de test (127) n'est déterminée pour l'une quelconque des grandeurs perturbatrices (128) générées des modules de moteur (117) sélectionnés comme modules de moteur perturbateurs (123).

13. Procédé (200) selon l'une des revendications précédentes, dans lequel les modules de moteur (117) de la pluralité de modules de moteur (117) de l'unité stationnaire (103) sont combinés pour former des chaînes de modules de moteur (135), dans lequel chaque chaîne de modules de moteur (135) comporte au moins deux modules de moteur (117) reliés entre eux par câble, et dans lequel le procédé (200) comprend :
la détermination, par l'unité de commande (109), lors d'une étape de détermination de module de moteur (221), d'un module de moteur d'extrémité de test (137) d'une chaîne de modules de moteur de test (139) et d'un module de moteur d'extrémité perturbateur (143) d'une chaîne de modules de moteur perturbateurs (145), le module de moteur d'extrémité de test (137) n'étant relié par câble qu'à un seul autre module de moteur (117) de la chaîne de modules de moteur de test (139), et le module de moteur d'extrémité perturbateur (143) n'étant relié par câble qu'à un seul autre module de moteur (117) de la chaîne de modules de moteur perturbateurs (145) ; et
la sélection, par l'unité de commande (109), lors d'une étape de sélection de module de moteur (223), du module de moteur d'extrémité de test (137) de la chaîne de modules de moteur de test (139) comme module de moteur de test (121) pour générer le champ magnétique de test (127), et la sélection du module de moteur d'extrémité perturbateur (143) de la chaîne de modules de moteur perturbateurs (145) comme module de moteur perturbateur (123) pour générer la grandeur perturbatrice (128).

14. Procédé (200) selon l'une des revendications précédentes, le procédé (200) comprenant en outre :
la détermination, par l'unité de commande (109), lors d'une étape de détermination de topologie (225), d'une topologie des modules de moteur (117) de l'unité stationnaire (103) par la détermination d'au moins un module de moteur (125) directement adjacent pour les modules de moteur (117) de la pluralité de modules de moteur (117) de l'unité stationnaire (103), et/ou le procédé étant mis en œuvre lors du démarrage du système de transport linéaire (100) et/ou après un ajout et/ou un retrait d'un module de moteur (117) à la pluralité de modules de moteur (117).

15. Système de transport linéaire (100) comportant une unité de commande (109) et une unité stationnaire (103), dans lequel l'unité stationnaire comprend un rail de guidage (105) pour guider une unité mobile (101) et une pluralité de modules de moteur (117) disposés le long du rail de guidage, les modules de moteur (117) comprenant respectivement des bobines d'entraînement (115) pour fournir un champ magnétique d'entraînement destiné à entraîner l'unité mobile (101) le long du rail de guidage, les bobines d'entraînement (115) étant conçues pour générer un champ magnétique de test (127) et/ou une grandeur perturbatrice (128), **caractérisé en ce que en ce que** l'unité de commande (109) est conçue pour mettre en œuvre le procédé pour faire fonctionner un système de transport linéaire (100) selon l'une des revendications précédentes 1 à 14.
